# EUROPEAN PATENT APPLICATION

(11) **EP 1 830 413 A1**
(43) Date of publication of application: **05.09.2007**
(21) Application number: 05805428.9
(22) Date of filing: 01.11.2005
(51) Int. Cl.: H01L 31/04, H01M 14/00

(54) **PHOTOELECTRIC ELEMENT COMPRISING ORGANIC THIN FILM HAVING MULTILAYERED STRUCTURE, PROCESS FOR PRODUCING THE SAME, AND SOLAR CELL**

(30) Priority: 01.11.2004 JP 2004317552; 09.09.2005 JP 2005262522
(71) Applicant: Kyoto University, Kyoto-shi, Kyoto 606-8501 (JP); Pioneer Corporation, Tokyo 1538654 (JP); ROHM CO., LTD., Kyoto-shi, Kyoto 615-8585 (JP); HITACHI, LTD., Chiyoda-ku Tokyo 100-8280 (JP)
(72) Inventor: ITO, Shinzaburo Kyoto University Graduate School, Kyoto-shi Kyoto 6158530 (JP); OHKITA, Hideo Kyoto University Graduate School, Kyoto-shi Kyoto 6158530 (JP)
(74) Representative: Beetz & Partner
(86) International application number: PCT/JP2005/020105
(87) International publication number: WO 2006/049166

(57) **Abstract**

By multiplexing light-harvesting layer and complexing with hole transport films or electron transport films, a photoelectric device and a solar cell exhibiting highly efficient electricity generation property can be obtained. A composite layer (11) in a photoelectric device (31) includes: a 1st light-harvesting film (A₁) that includes photosensitive groups which absorb light energy and are excited thereby; a 1st hole transport film (P₁) containing electron-donating groups that donate electrons to photosensitive groups; an nth light-harvesting film (Aₙ) that includes photosensitive groups which absorb light energy that has passed through an (n-1) th light-harvesting film (Aₙ₋₁) and are excited thereby; an nth hole transport film (Pₙ) that is sandwiched between the nth light-harvesting film (An) and the (n-1) th light-harvesting film (Aₙ₋₁) and includes electron-donating groups for donating electrons to the excited photosensitive groups; light-harvesting film connectors (41) that connect the (n-1)th light-harvesting film (Aₙ₋₁) and the nth light-harvesting film (Aₙ); and hole transport film connectors (42) that connect an (n-1)th hole transport film (Pₙ₋₁) and the nth hole transport film (Pₙ).

## Description

### Technical field

The present invention relates to a photovoltaic technology using an organic thin film, and particularly to a photoelectric device with an organic thin film having a multilayer structure, a method for producing the same and a solar cell.

### Background art

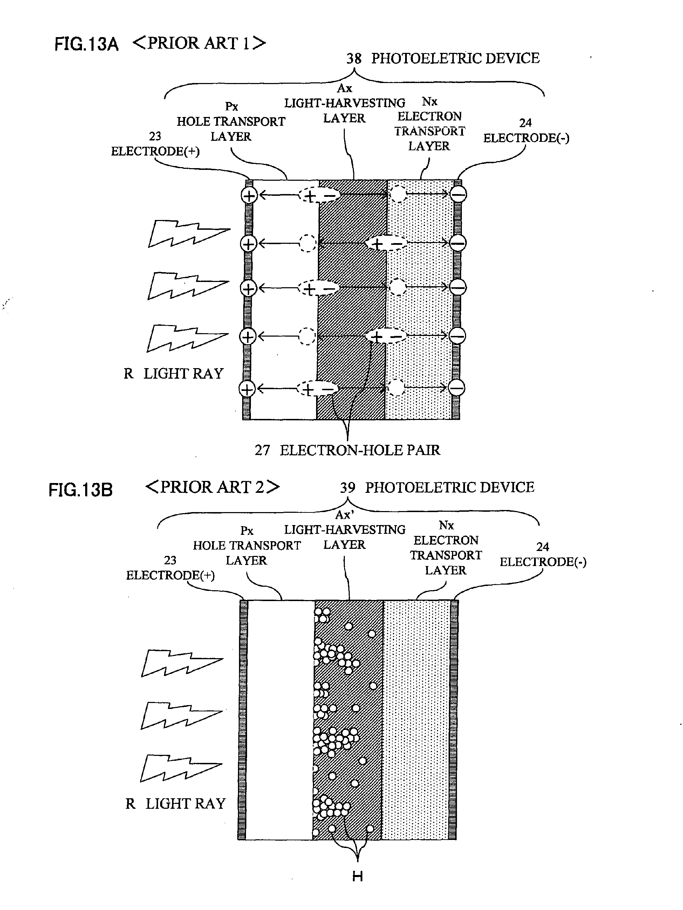

FIG. 13 is a schematic view showing photoelectric devices using conventional organic thin films: FIG. 13A shows a configuration and power-generation mechanism of a first prior art, and FIG. 13B shows a configuration of a second prior art.

As shown in FIG. 13A, in a conventional photoelectric device 38, on a transparent electrode (electrode 23) deposited on a transparent support, such as a glass, there are stacked: a hole transport layer Px composed of an organic semiconductor film having electron-donating property; a light-harvesting layer Ax containing photosensitive groups that are excited by absorbing light energy of incident light ray R; an electron transport layer Nx composed of an organic semiconductor film having electron-accepting property; and a counter electrode (electrode 24) disposed thereon. It should be noted that a stacking order of the above-mentioned hole transport layer Px and electron transport layer Nx may be switched, or only one of them may be stacked (see, for example, Japanese unexamined patent application laid-open specification Nos. H7-240530 and H5-259493).

Next, a working mechanism of the conventional photoelectric device 38 shown in FIG. 13A will be described. First, when light ray R enters the transparent electrode (electrode 23) and is absorbed by the light-harvesting layer Ax, the photosensitive groups included in the light-harvesting layer Ax are excited, and as shown in FIG. 13A, electron-hole pairs 27,27... are formed in a vicinity of interfaces.

From each of the electron-hole pairs 27,27... formed in a vicinity of the interface between the light-harvesting layer Ax and the hole transport layer Px, a hole (+) is separated and taken in the hole transport layer Px. The taken hole (+) is transported to the electrode 23 through the hole transport layer Px.

On the other hand, an electron (-) from the electron-hole pair 27 remaining after the separation of the hole (+) moves through the light-harvesting layer Ax and reaches an interface with the electron transport layer Nx, on the other side of the light-harvesting layer Ax (herein, this interface is sometimes referred to as "opposite interface"). The electron (-) that has reached the opposite interface is transported to the electrode 24 through the electron transport layer Nx.

Likewise, from each of the electron-hole pair 27,27... formed in a vicinity of the interface between the light-harvesting layer Ax and the electron transport layer Nx, an electron (-) is separated and taken in the electron transport layer Nx. The taken electron (-) is transported to the electrode 24 through the electron transport layer Nx. On the other hand, a hole (+) of the electron-hole pair 27 remaining after the separation of the electron (-) moves through the light-harvesting layer Ax and reaches the interface with the hole transport layer Px, on the other side of the light-harvesting layer Ax (herein, this interface is sometimes referred to as "opposite interface"). The hole (+) that has reached the opposite interface is transported to the electrode 23 through the hole transport layer Px.

In this manner, of the electron-hole pairs 27,27... generated on the interfaces between the light-harvesting layer Ax and the hole transport layer Px, and between the light-harvesting layer Ax and the electron transport layer Nx, the hole (+) and the electron (-) that have reached their respective opposite interfaces by moving through the light-harvesting layer Ax after charge separation are transported to their respective electrodes 23,24, and an electrical potential is generated between two electrodes. If the electrodes 23,24 are short-circuited through an external load (not shown) and light ray R is radiated on the photoelectric device 38, the photoelectric device 38 generates electricity and electric power is constantly output.

In order to efficiently generate electricity with the devices such as the photoelectric device 38, attempts have been made to improve absorptivity of light energy without allowing transmission of light ray R through the device, and to attain smooth movement of electrons (-) and/or holes (+) through the light-harvesting layer Ax.

Specifically, proposals have been made to optimize layer thicknesses of the layers (hole transport layer Px, light-harvesting layer Ax and electron transport layer Nx), or as shown in FIG. 13B, to admix the component H of the hole transport layer Px or the component of the electron transport layer Nx with an light-harvesting layer Ax' , in order to improve hole (+)- or electron (-)- conducting property of the light-harvesting layer Ax'.

If an attempt is made to make the photoelectric device 38 prevent light ray R from transmitting through the photoelectric device 38 and absorb light energy thereof at high efficiency, one possible solution may be to make the light-harvesting layer Ax (see FIG. 13A) thicker. However, thickening of the light-harvesting layer Ax keeps the interface with the hole transport layer Px and the interface with the electron transport layer Nx away, and hinders smooth movement of electrons (-) and holes (+) generated at the interfaces to their respective opposite interfaces. Therefore, increasing the layer thickness of the light-harvesting layer Ax does not necessarily leads to efficient electricity generation by the photoelectric device 38.

On the other hand, the attempt that has been described above with referring to FIG. 13B may solve the problem that occurs due to increase in the layer thickness of the light-harvesting layer Ax, since adding such a composition has an effect of improving conductivity of holes (+) or electrons (-) through the light-harvesting layer Ax. However, it was elucidated by experiments that such an attempt cannot achieve expected drastic improvement in electricity generation efficiency of the conventional photoelectric device 38.

Therefore, it would be desirable to drastically improve electricity generation efficiency of the conventional photoelectric device 38.

### Disclosure of the invention

The present inventors made intensive and extensive studies with the view toward solving the above-mentioned problems. As a result, by multiplexing the light-harvesting layer Ax, and complexing with the hole transport film or the electron transport film, a photoelectric device and a solar cell exhibiting high efficiency in electric generation property are realized, and completed the present invention.

In an aspect of the present invention, there are provided the following photoelectric devices:
[1] a photoelectric device having a composite layer and a pair of electrodes disposed on both sides of the composite layer,
   the composite layer including: a 1st light-harvesting film that includes photosensitive groups which absorb light energy and are excited thereby, a 1st hole transport film that neighbors the 1st light-harvesting film and includes electron-donating groups for donating electrons to the excited photosensitive groups, an nth light-harvesting film (n=2, 3...) that includes photosensitive groups which absorb light energy that has passed through an (n-1)th light-harvesting film and are excited thereby, an nth hole transport film (n=2, 3...) that is sandwiched between the nth light-harvesting film and the (n-1) th light-harvesting film and includes electron-donating groups for donating electrons to the excited photosensitive groups, light-harvesting film connectors that penetrate the nth hole transport film and connect the (n-1) th light-harvesting film and the nth light-harvesting film, and hole transport film connectors that penetrate the (n-1) th light-harvesting film and connect an (n-1) th hole transport film and the nth hole transport film, and
[2] a photoelectric device having a composite layer and a pair of electrodes disposed on both sides of the composite layer,
   the composite layer including: a 1st light-harvesting film that includes photosensitive groups which absorb light energy and are excited thereby, a 1st electron transport film that neighbors the 1st light-harvesting film and includes an electron-accepting groups for accepting electrons from the excited photosensitive groups, an nth light-harvesting film (n=2, 3...) that includes photosensitive groups which absorb light energy that has passed through an (n-1) th light-harvesting film and are excited thereby, an nth electron transport film and an (n-1) th electron transport film that sandwiches the nth light-harvesting film and includes electron-accepting groups for accepting electrons from the excited photosensitive groups, light-harvesting film connectors that penetrate the (n-1)th electron transport film and connect the (n-1)th light-harvesting film and the nth light-harvesting film, electron transport film connectors that penetrate the nth light-harvesting film and connect the (n-1) th electron transport film and the nth electron transport film.

With this configuration, an electron and/or a hole generated by charge separation of an electron-hole pair at an interface of the light-harvesting film can smoothly move through the composite layer and reach their respective electrodes.

According to the present invention, light energy of light ray entered the photoelectric device is converted into electrical energy at high efficiency, and therefore, a photoelectric device and a solar cell exhibiting high efficiency in electric generation property can be obtained.

The various aspects and effects, other advantages and further features of the present invention will become more apparent by describing in detail illustrative, non-limiting embodiments thereof with reference to the accompanying drawings.

### Brief Description of the drawings

FIG. 1A is a schematic diagram showing a photoelectric device according to a first embodiment, and FIGs. 1B - 1D are diagrams showing different combinations of films forming interfaces on both sides of a composite layer.
FIG. 2 is a schematic diagram illustrating a concept of formation of alternate layer-by-layer adsorption film (alternate layer-by-layer adsorption method).
FIG. 3 is a schematic diagram illustrating production steps of the alternate layer-by-layer adsorption film.
FIG. 4 is a cross sectional view of a solar cell according to the present invention.
FIG. 5A is a schematic diagram showing a photoelectric device according to a second embodiment, and FIGs. 5B - 5D are diagrams showing different combinations of films forming interfaces on both sides of a composite layer.
FIG. 6 is a schematic diagram showing a photoelectric device according to a third embodiment.
FIGs. 7A - 7D are schematic diagrams showing various types of photoelectric device in which a hole transport layer or an electron transport layer is sandwiched between a composite layer and an electrode.
FIG. 8A shows structural formulae of electron-donating groups contained in a hole transport film, photosensitive groups contained in a light-harvesting film and electron-accepting groups contained in an electron transport film illustratively used in Examples; FIG. 8B shows structural formulae of polyelectrolyte forming an adhesive film illustratively used in Examples; and FIG. 8C shows substances contained in a charge separation film illustratively used in Examples.
FIG. 9A is a schematic diagram showing a photoelectric device (ITO/PEDOT+Ru/C₆₀/Al) as an example; and FIG. 9B shows observation data of photocurrent response in this example.
FIG. 10A is a schematic diagram showing a photoelectric device (ITO/PEDOT/Ru/C₆₀/Al) as a comparative example; and FIG. 10B shows observation data of photocurrent response in this comparative example.
FIG. 11A is a schematic diagram showing a photoelectric device (ITO/PPV+PEDOT/C₆₀/Al) as an example; FIG. 11B is a schematic diagram showing a photoelectric device (ITO/PEDOT/PPV+PEDOT/C₆₀/Al) as an example; FIG. 11C is a schematic diagram showing a photoelectric device (ITO/PEDOT/PEDOT+PPV/C₆₀/Al) as an example; FIG. 11D shows observation data of photocurrent response in the example of FIG. 11A; FIG. 11E shows observation data of photocurrent response in the example of FIG. 11B; and FIG. 11F shows observation data of photocurrent response in the example of FIG. 11C.
FIG. 12A is a schematic diagram showing a photoelectric device (ITO/PEDOT/Ru/C_{60/}Al) as a comparative example; FIG. 12B is a schematic diagram showing a photoelectric device (ITO/PEDOT/Ru+PEDOT/C₆₀/Al) as an example; FIG. 12C is observation data of photocurrent response in the comparative example of FIG. 12A; and FIG. 12D shows observation data of photocurrent response in the example of FIG. 12B.
FIG. 13 is a schematic view showing conventional photoelectric devices: FIG. 13A shows a configuration and power-generation mechanism of a first prior art; and FIG. 13B shows a configuration of a second prior art.

### Best modes for carrying out the invention

### (First embodiment)

Hereinafter, a first embodiment of the present invention will be described with reference to the drawings.

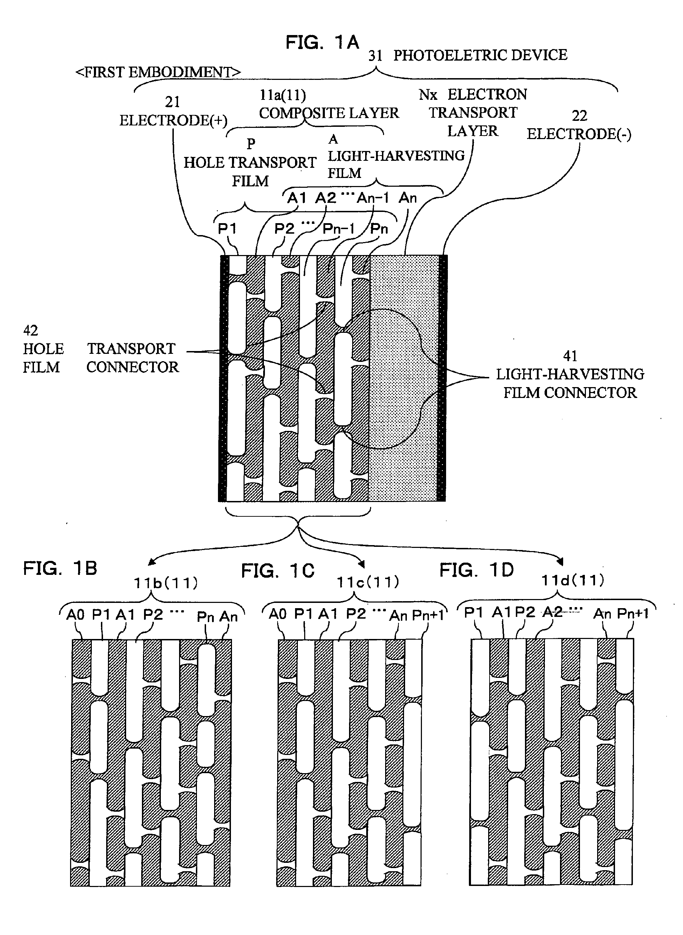

FIG. 1 is a schematic diagram showing a photoelectric device 31 according to a first embodiment.

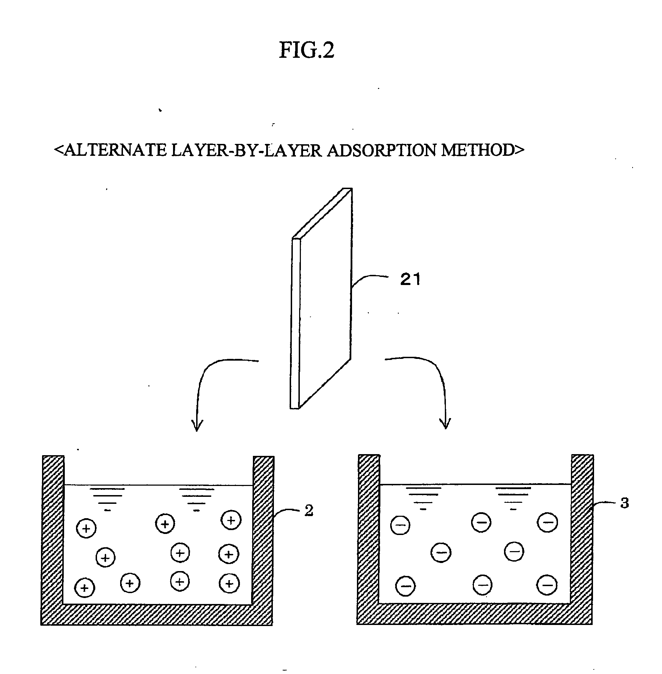

FIG. 2 is a schematic diagram illustrating a concept of formation of alternate layer-by-layer adsorption film (alternate layer-by-layer adsorption method).

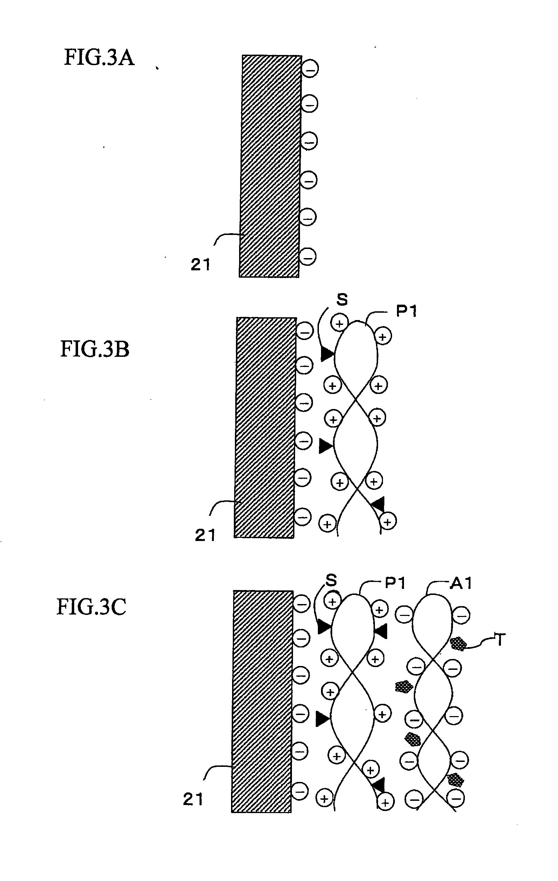

FIG. 3 is a schematic diagram illustrating production steps of the alternate layer-by-layer adsorption film.

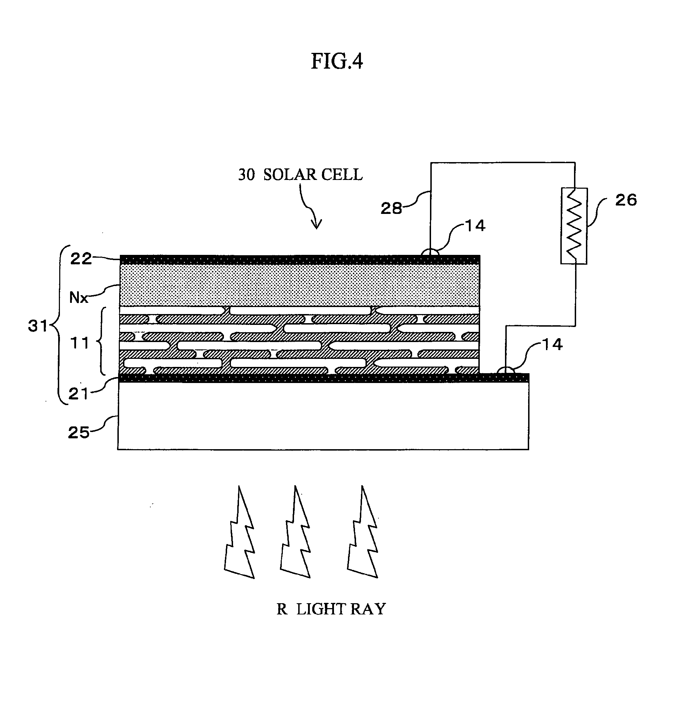

FIG. 4 is a cross sectional view of a solar cell according to the present invention.

As shown in FIG. 1A, in a photoelectric device 31 according to the first embodiment, a pair of electrodes 21,22 sandwiches a composite layer 11a (11) and an electron transport layer Nx. The composite layer 11 has a multilayer structure in which a plurality of hole transport films P (P₁, P₂... Pₙ₋₁, Pₙ) and a plurality of light-harvesting films A (A₁, A₂... Aₙ₋₁, Aₙ) are alternately stacked.

In the following descriptions, when an individual hole transport film and an individual light-harvesting film are intended to be specified, they are referred to as, for example, "1st hole transport film P₁, 2nd hole transport film P₂,..." and "1st light-harvesting film A₁", respectively, and when individual films are not intended to be specified, they are collectively referred to as, for example, "hole transport film P", and "light-harvesting film A", respectively.

With the proviso that n is a positive integer of 2 or more, a hole transport film Pₙ₋₁ and a hole transport film Pₙ sandwiches a light-harvesting film Aₙ₋₁ while contacting with the light-harvesting film A_{n-1,} and are connected through a plurality of hole transport film connectors 42,42.... These hole transport film connectors 42, 42... are made of the same material as that of the hole transport film Pₙ₋₁ or the hole transport film Pₙ to which both ends of the hole transport film connector 42 are connected, and penetrate through the light-harvesting film Aₙ₋₁ made of a different material.

Likewise, with the proviso that n is a positive integer of 2 or more, the light-harvesting film Aₙ₋₁ and a light-harvesting film An sandwiches the hole transport film Pₙ while contacting with the hole transport film Pₙ, and are connected through a plurality of light-harvesting film connectors 41,41.... These light-harvesting film connectors 41,41... are made of the same material as that of the light-harvesting film Aₙ₋₁ or the light-harvesting film An to which both ends of the light-harvesting connector 41 are connected, and penetrate through the hole transport film Pₙ made of a different material.

Such connectors 41,42 are not limited to connectors which physically connect films of the same type by physically penetrating through a sandwiched film of a different type, but also include any connectors as long as they have a function of relaying transport carriers of electric energy, such as electron and hole, or transport carriers of photoexcitation energy, from a film to a film, as will be described below.

Herein, of the electrodes 21,22, one electrode into which light ray (not shown) enters is a transparent electrode made of a material having a transmissibility to light ray and electric conducting property. The counter electrode thereof may be made of a metallic substance having high electric conducting property, or may be a transparent electrode.

The light-harvesting film A (A₁, A₂... Aₙ₋₁, Aₙ) is an organic thin film to which photosensitive groups that are excited upon absorbing light energy of light ray are added as functional group. Herein, the expression "exited photosensitive group" or similar expression means a state in which a pair of electrons in HOMO (Highest Occupied Molecular Orbital) are shifted to LUMO (Lowest Unoccupied Molecular Orbital). When the photosensitive groups are in such an excited state, energy can be transferred between adjacent photosensitive groups. Therefore, in the light-harvesting film A, energy can be transferred from one interface to the opposite interface.

The hole transport film P (P₁, P₂... Pₙ₋₁, Pₙ) is an organic thin film to which electron-donating groups that tend to push out electrons therefrom are added as functional group. At an interface with the adjacent light-harvesting film A, the hole transport film P donates an electron to the electron-hole pair generated by absorption of light energy, to thereby separate a charge and receive a hole (+). The received hole (+) moves through the hole transport film P (P₁, P₂... Pₙ₋₁, Pₙ) along the hole transport film connector 42, and reaches the electrode 21.

A hole (+) separated from the electron-hole pair generated at the interface of an nth light-harvesting film An and the electron transport layer Nx moves through the hole transport film P (P₁, P₂... Pₙ₋₁, Pₙ), and reaches the electrode 21.

The electron transport layer Nx is an organic layer or inorganic layer to which electron-accepting groups that tend to attract electrons thereto are added. The electron transport layer Nx receives an electron (-) generated at the interface with the nth light-harvesting film An and transports the electron (-) to the electrode 22.

On the composite layer 11, the electron transport layer Nx may be formed by alternate layer-by-layer adsorption method which will be described below, or by other physical or chemical means, such as coating and evaporation (deposition).

Meanwhile, some factors to improve electricity generation efficiency of the photoelectric device 31 include to efficiently generate electron-hole pairs at the interface of the light-harvesting film A, and to enhance smooth movement of electrons and holes directing to their respective interfaces through the composite layer 11.

In order to attain the above, it is desirable that the composite layer 11 be a multilayer composed of the light-harvesting films A and the hole transport films P, and at the same time, the distance between the interface and the opposite interface be not far so that hole and electron generated by charge separation are transferred between interfaces without disappearing by recombination.

A layer thickness of the composite layer 11 that attains the above-mentioned conditions may be 2 nm - 200 nm, preferably 5 nm - 100 nm. A layer thickness of each of the hole transport film P (P₁, P₂... Pₙ₋₁, Pₙ) and the light-harvesting film A (A₁, A₂... Aₙ₋₁, An) is 0.5 nm - 30nm, preferably 1 nm - 10nm, and a plurality of the light-harvesting films A and the plurality of the hole transport films P are alternately stacked in such a manner that the total thickness does not exceed the above-defined layer thickness. There is no limitation with respect to a combination of the film thicknesses of the hole transport films P (P₁, P₂... Pₙ₋₁, Pₙ) and the film thickness of the light-harvesting films A (A₁, A₂... Aₙ₋₁, An) : all films may have different thicknesses, some films may have the same thickness, or all films may have the same thickness.

The reason for the above-mentioned thickness range of the components of the composite layer 11 is as follows. The lower limit of the film thickness for each of the hole transport film P (P₁, P₂... Pₙ₋₁, Pₙ) and the light-harvesting film A (A₁, A₂... Aₙ₋₁, An) is 0.5 nm, since it is physically impossible to form a thinner film. The upper limit is 30 nm, since a thicker film requires longer connectors that penetrate through a film and connect two films sandwiching the film, leading to increase in internal resistance and thus to lowering of electricity generation efficiency.

The lower limit of the layer thickness for the composite layer 11 is 2 nm, since a thinner composite layer 11 allows more incident light ray to transmit through without converting light energy into electrical energy, leading to lowering of electricity generation efficiency. The upper limit of the layer thickness of the composite layer 11 is 200 nm, since a thicker composite layer 11 increases internal resistance and thus lowers electricity generation efficiency.

Examples of materials to be used in the above-mentioned transparent electrode include ITO (indium tin oxide), IZO (indium zinc oxide), TiO₂, SnO₂ and ZnO.

Examples of metallic substance to be used in the counter electrode to the transparent electrode include Al, Au and Pt.

Examples of the photosensitive groups include functional groups based on ruthenium complex, fullerene, coumarin, carbazole, porphyrin, phthalocyanine, thiophene, spiro, ferrocene, fluorenone, fulgide, imidazole, perylene, phenazine, phenothiazine, polyene, azo, quinone, indigo, diphenylmethane, triphenylmethane, polymethine, acridine, acridinone, carbostyril, diphenylamine, quinacridone, quinophthalone, phenoxazine, phthaloperinone, porphine, chlorophyll, phthalocyanine, crown, squarylium, and thiafulvalene.

Examples of the electron-donating groups include functional groups based on thiophene, ferrocene, p-phenylenevinylene, carbazole, pyrrole, aniline, diamine, phthalocyanine and hydrazone.

Examples of the electron-accepting groups include derivatives and metal complexes of fullerene, oxadiazole, oxadol, perylene and naphthalene.

It should be noted that the photosensitive groups, the electron-donating groups, and the electron-accepting groups in the present invention are not limited to those introduced to a main chain or a side chain of a polymer, and include, for example, those in a monomeric state.

### (Production method)

Next, with referring to FIGs. 2 and 3, a method for producing a photoelectric device according to the first embodiment will be described. The composite layer 11 of the photoelectric device 31 according to the first embodiment (see FIG. 1) can be formed by alternate layer-by-layer adsorption method which will be described below. Herein, the "alternate layer-by-layer adsorption method" means a method for obtaining an alternate layer-by-layer adsorption film, in which an aqueous solution 2 containing cation and an aqueous solution 3 containing anion are prepared in separate vessels, and the substrate electrode 21 whose surface is initially charged is alternately immersed in the solutions in the vessels, as shown in FIG. 2, to thereby obtain a multilayer structure on the substrate electrode 21. It should be noted that cation and anion used in the alternate layer-by-layer adsorption method may be in a form of polymer or low molecule.

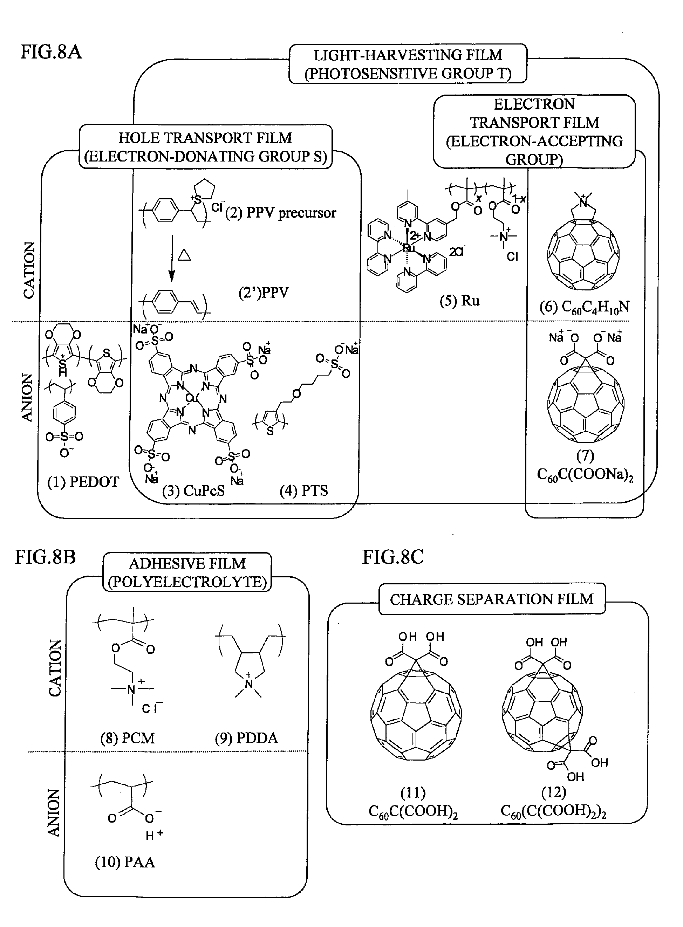

First, as shown in FIG. 3A, a surface of the substrate electrode (electrode 21) is negatively charged. When the substrate electrode 21 having the negatively charged surface is immersed in the solution including cation to which electron-donating groups S have been introduced (see FIG. 8A as appropriate), cation to which electron-donating groups S have been introduced is adsorbed on the surface by Coulomb force, to thereby form an ultrathin film composed of a single-layered 1st hole transport film P₁, as shown in FIG. 3B. The surface of the thus formed hole transport film P₁ is positively charged.

When the substrate electrode 21 is immersed in the solution including anion to which photosensitive groups T have been introduced (see FIG. 8A as appropriate), anion is adsorbed by Coulomb force, to thereby form an ultrathin film composed of a single-layered 1st light-harvesting film A₁, as shown in FIG. 3C. In this manner, by alternately immersing the substrate electrode 21 in the solutions in two vessels, a hole transport film P including electron-donating groups S and a light-harvesting film A including photosensitive groups T are alternately formed, which in turn gives a composite layer 11 having a multilayer structure (see FIG. 1).

In the embodiment above, the functional group in the cation is electron-donating group S, and the functional group in the anion is photosensitive group T. However, photosensitive groups T may be introduced as functional group to the cation, and electron-donating groups S may be introduced as functional group to the anion (see FIG. 8A as appropriate). In the embodiment above, the surface of the substrate electrode 21 is initially charged negative. However, the surface charge may be initially positive, and in this case, anion is adsorbed to the substrate electrode 21 first.

A film thickness of the adsorption film formed on a surface by single immersion of the substrate electrode 21 can be controlled in a range of 0.5 - 30 nm, though it varies depending on given conditions. By immersing the substrate electrode 21 alternately in the cation-containing aqueous solution and the anion-containing aqueous solution, a layer number of the adsorption film can be increased, to thereby quantitatively control the entire layer thickness, with a film thickness of the above-mentioned single layer as a single unit.

In addition, in the alternate layer-by-layer adsorption film formed of the hole transport film P and the light-harvesting film A obtained by this alternate layer-by-layer adsorption method, the adjacent (n-1)th hole transport film Pₙ₋₁ and nth hole transport film Pₙ are not completely separated by the nth light-harvesting film An sandwiched therebetween, but are connected to each other by penetrations through the nth light-harvesting film An. Likewise, the adjacent (n-1)th light-harvesting film Aₙ₋₁ and nth light-harvesting film An are not completely separated by the nth hole transport film Pₙ sandwiched therebetween, but are connected to each other by penetrations through the nth hole transport film Pₙ. The penetrations through the light-harvesting film A or the hole transport film P connecting two films of the same type on the both sides of the penetrated film in the above-mentioned manner correspond to the hole transport film connector 42 and the light-harvesting film connector 41, respectively. The formation of the connector may be due to a defect in the adsorption film alternatively stacked, or interpenetration of polymer chains composing the adsorption film, and the like.

Though not shown in FIG. 2, it is preferable that a cleaning vessel be further provided and the substrate electrode 21 be rinsed in the cleaning vessel after immersion in the solution in one of the vessels and before immersion in the solution in the other vessel, in order to prevent the liquid in one vessel from being contaminated with the liquid in the other vessel attached to a surface of the substrate electrode 21.

The formation of the composite layer 11 of FIG. 1 by alternate layer-by-layer adsorption method has been described. The electron transport layer Nx can be also formed subsequently by alternate layer-by-layer adsorption method. Specifically, the substrate electrode 21 on which the composite layer 11 has been formed is immersed in an aqueous solution of cation to which electron-accepting groups have been introduced. Next, the substrate electrode 21 is immersed in an aqueous solution of anion to negatively charge the entire substrate electrode 21. This anion merely functions as an adhesive film for stacking a next cation film to which electron-accepting groups have been introduced. By alternately repeating these procedures, an electron transport layer Nx having a specific layer thickness is formed. Further, the electrode 22 can be formed on the exposed surface of the electron transport layer Nx by evaporation and the like, to thereby obtain the photoelectric device 31.

For the anion to be used as the adhesive film, there can be mentioned a polymer having carboxylic acid and a polymer having sulfonic acid. Examples of the anionic polymer having carboxylic acid include polyacrylic acid, polymethyl acrylate and poly(thiophene-3-acetic acid). Examples of the anionic polymer having sulfonic acid include polystyrene sulfonate, polyvinyl sulfonate, poly(3-sulfopropylmethacrylate), poly (aniline-sulfonic acid) and poly(3-thiophenealkanesulfonic acid) (see FIG. 8B).

For the cation to be used as the adhesive film, there can be mentioned a polymer having ammonium groups and a polymer having pyridyl groups. Examples of the cationic polymer having ammonium groups include polyethylene-imine, polyamylamine and poly(coline methacrylate). Examples of cationic polymer having pyridyl groups include polyvinylpyridine, polyvinylethylpyridine and poly(p-methyl pyridinium vinylene) (see FIG. 8B). (Configuration of solar cell)

FIG. 4 is a cross sectional view of a solar cell formed of a photoelectric device, according to the present invention. As shown in FIG. 4, in a solar cell 30, a transparent substrate 25 supports a photoelectric device 31, with a transparent electrode (electrode 21) of the photoelectric device 31 being brought into contact with the transparent substrate 25. On each of the electrodes 21,22, a conducting wire 28 is disposed, with one terminal thereof fixed by a terminal contact 14. When light ray R enters the solar cell 30, electricity is generated by photovoltaic reaction, and is output to an external load 26 through the conducting wire 28. It should be noted that the transparent substrate 25 may be made of glass, plastics or the like.

### (Description of working mechanism)

Referring to FIGs. 1 and 4, working mechanism of electricity generation when light ray R enters the solar cell 30 will be described.

First, light ray R transmits through the transparent substrate 25 (electrode 21) and enters the composite layer 11 from one side thereof. When the incident light ray passes through the 1st light-harvesting film A₁, a part of light energy thereof is absorbed. As the light ray passes through the 2nd, 3rd... nth light-harvesting films A₂, A₃, ... Aₙ, light energy is gradually absorbed. The light ray that has completely penetrated through the composite layer 11 is reflected by the counter electrode 22, and again enters the composite layer 11, to be gradually absorbed by the light-harvesting film A.

The photosensitive groups in each of the light-harvesting films A (A₁, A₂... Aₙ₋₁, Aₙ) that have absorbed light energy in this manner transit to an excited state. Energy is transferred between the excited photosensitive group and its adjacent photosensitive group. As a result, photoexcitation energy is transported to the interface between the hole transport film P and the light-harvesting film A and an electron-hole pair is formed. The electron-hole pair receives electron (-) from the electron-donating group in the hole transport film P and thus hole (+) is separated, which is then taken in the hole transport film P. On the other hand, hole (+) generated by charge separation of the electron-hole pair in the interface with the electron transport layer Nx is taken in the closest nth hole transport film Pₙ.

In addition, since a total area of the interface formed between the light-harvesting film A (A₁, A₂... Aₙ₋₁, An) and the hole transport film P (P₁, P₂... Pₙ₋₁, Pₙ) is large, a number per unit time of electron-hole pair, which is separated by receiving electron from the electron-donating group in the hole transport film P (P₁, P₂... Pₙ₋₁, Pₙ), is enormous.

Therefore, a number of hole (+) taken in the hole transport film P (P₁, P₂... Pₙ₋₁, Pₙ) is enormous, all of which are transported to the electrode 21. On the other hand, for every electron (-) generated at the same time by charge separation is transported to the counter electrode 22 by the function of the electron transport layer Nx.

As a result, positive electrons are accumulated in the electrode 21, and negative electrons are accumulated in the counter electrode 22, which generates a potential difference between the electrodes. Then, as shown in FIG. 4, when the electrodes 21,22 are short-circuited through the external load 26, the external load 26 is supplied with a large electric power.

In the description of the first embodiment, the electron transport layer Nx shown in FIG. 1 is not an essential component, and can be omitted. Specifically, the electrodes 21,22 may be directly disposed on both sides of the composite layer 11 (11a, 11b, 11c or 11d) shown in FIG. 1. When the electron transport layer Nx is omitted, the light-harvesting film A (A₁, A₂... Aₙ₋₁, An) has a function of transporting electron (-) to the electrode 22. Alternatively, the light-harvesting film A (A₁, A₂... Aₙ₋₁, An) may have a function of transporting hole (+) to the electrode 21.

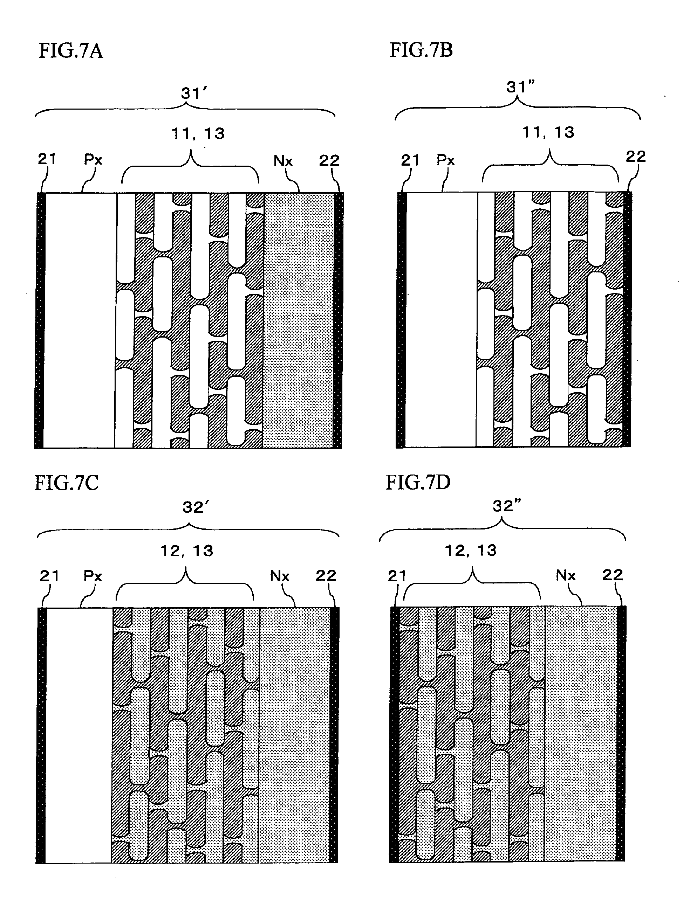

Further, a hole transport layer Px may be inserted between the electrode 21 and the composite layer 11 of the photoelectric device 31 shown in FIG. 1, as photoelectric devices 31', 31" shown in FIGs. 7A and 7B.

In the composite layer 11a of FIG. 1A in which the hole transport films P and the light-harvesting films A are alternately stacked, the hole transport film P forms the interface with the electrode 21 and the light-harvesting film A forms the interface with the electron transport layer Nx. However, the technical scope of the present invention is not limited to this configuration.

In other words, the film brought into contact with the electron transport layer Nx at the interface may be the light-harvesting film An as shown in the composite layer 11a of FIG. 1A and the composite layer 11b of FIG. 1B, or may be the hole transport film Pₙ₊₁ as shown in the composite layer 11c of FIG. 1C and the composite layer 11d of FIG. 1D.

The film brought into contact with the electrode 21 at the interface may be the light-harvesting film A₀ as shown in the composite layer 11b of FIG. 1B and the composite layer 11c of FIG. 1C, or may be the hole transport film P₁ as shown in the composite layer 11a of FIG. 1A and the composite layer 11d of FIG. 1D.

### (Second embodiment)

Hereinafter, a second embodiment of the present invention will be described with reference to the drawings.

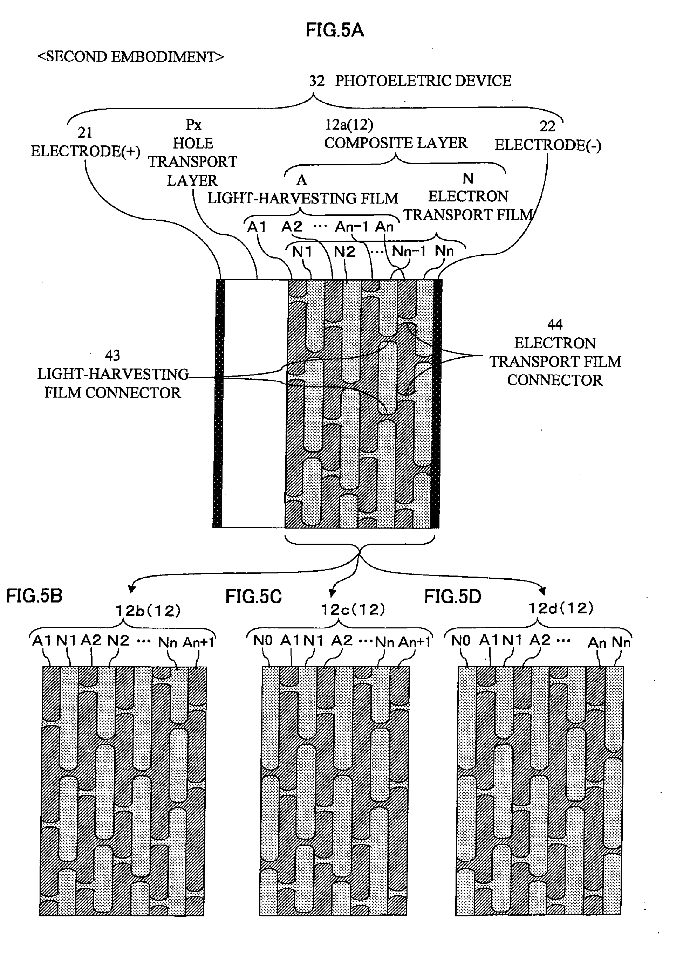

FIG. 5A is a schematic diagram showing a photoelectric device 32 according to a second embodiment.

As shown in FIG. 5, in a photoelectric device 32 according to the second embodiment, a pair of electrode 21,22 sandwiches a composite layer 12a(12) and an hole transport layer Px. The composite layer 12 has a multilayer structure in which a plurality of electron transport films N (N₁, N₂... Nₙ₋₁, Nₙ) and a plurality of light-harvesting films A (A₁, A₂... Aₙ₋₁, An) are alternately stacked.

With the proviso that n is a positive integer of 2 or more, an (n-1) th electron transport film Nₙ₋₁ and an nth electron transport film Nₙ sandwiches an nth light-harvesting film Aₙ while contacting with the nth light-harvesting film Aₙ, and are connected through a plurality of electron transport film connectors 44,44.... These electron transport film connectors 44,44... penetrate through the nth light-harvesting film An and both ends of the electron transport film connector 42 are connected to the (n-1) th electron transport film Nₙ₋₁ and the nth electron transport film Nₙ.

Likewise, with the proviso that n is a positive integer of 2 or more, an (n-1) th light-harvesting film Aₙ₋₁ and the nth light-harvesting film An sandwiches the (n-1)th electron transport film Nₙ₋₁ while contacting with the (n-1) th electron transport film Nₙ₋₁, and are connected through a plurality of light-harvesting film connectors 43,43.... These light-harvesting film connectors 43,43... penetrate through the electron transport film Nₙ₋₁ and both ends of the light-harvesting film connector 43 are connected to the light-harvesting film Aₙ₋₁ and the light-harvesting film An.

The photoelectric device 32 according to the second embodiment has almost the same configuration as that of the photoelectric device 31 according to the first embodiment (see FIG. 1), except that the hole transport film P (P₁, P₂... Pₙ₋₁, Pₙ) is replaced with the electron transport film N (N₁, N₂... Nₙ₋₁, Nₙ).

Therefore, working mechanism differs only in that, from electron-hole pair generated at the interface between the light-harvesting film A and the electron transport film N, electron (-) is separated to an electron transport film N side and transported to the electrode 22, due to electron-accepting groups introduced to the electron transport film N, and that hole (+) is generated at the interface with the hole transport layer Px and transported to the electrode 21.

Accordingly, detailed working mechanism, production method and the like of the photoelectric device 32 according to the second embodiment can be explained with the description of the first embodiment simply by exchanging the functional descriptions regarding the hole transport film P and the electron transport film N, and therefore omitted here.

In the description of the second embodiment, the hole transport layer Px shown in FIG. 5 is not an essential component, and can be omitted. Specifically, the electrodes 21,22 may be directly disposed on both sides of the composite layer 12 (12a, 12b, 12c or 12d) shown in FIG. 5. When the hole transport layer Px is omitted, the light-harvesting film A (A₁, A₂... Aₙ₋₁, An) has a function of transporting hole (+) to the electrode 21. Alternatively, the light-harvesting film A (A₁, A₂... Aₙ₋₁, An) may have a function of transporting electron (-) to the electrode 22.

Further, an electron transport layer Nx may be inserted between the electrode 22 and the composite layer 12 of the photoelectric device 32 shown in FIG. 5, as photoelectric devices 32',32" shown in FIGs. 7C and 7D.

In the composite layer 12a of FIG. 5A in which the electron transport films N and the light-harvesting films A are alternately stacked, the electron transport film N forms the interface with the electrode 22 and the light-harvesting film A forms the interface with the hole transport layer Px. However, the technical scope of the present invention is not limited to this configuration.

In other words, the film brought into contact with the hole transport layer Px at the interface may be the light-harvesting film A₁ as shown in the composite layer 12a of FIG. 5A and the composite layer 12b of FIG. 5B, or may be the electron transport film No as shown in the composite layer 12c of FIG. 5C and the composite layer 12d of FIG. 5D.

The film brought into contact with the electrode 22 at the interface may be the light-harvesting film Aₙ₊₁ as shown in the composite layer 12b of FIG. 5B and the composite layer 12c of FIG. 5C, or may be the electron transport film Nₙ as shown in the composite layer 12a of FIG. 5A and the composite layer 12d of FIG. 5D.

### (Third embodiment)

Hereinafter, a third embodiment of the present invention will be described with reference to the drawings.

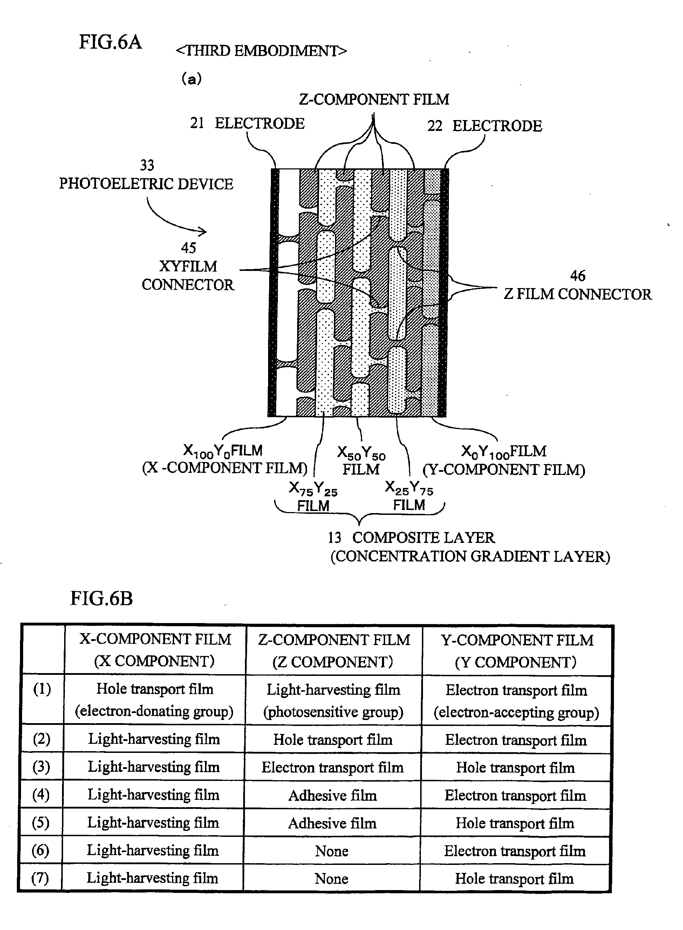

FIG. 6A is a schematic diagram showing a photoelectric device 33 according to a third embodiment. The photoelectric device 33 shown in FIG. 6 is substantially the same as the photoelectric devices 31,32 according to the first and second embodiments described above in that it has a composite layer 13 and a pair of electrodes 21,22 as basic components. The difference of the photoelectric device 33 according to the third embodiment is that the functional groups introduced have a concentration gradient in a film thickness direction of the composite layer 13.

X-, Y- and Z-component films forming the composite layer 13 may be combined in various patterns, as shown in (1) - (7) of FIG. 6B. Specifically, suppose that one combination pattern does not include two or more films of the same type, the X-component film may be a hole transport film containing electron-donating groups or a light-harvesting film containing photosensitive groups; the Y-component film may be an electron transport film containing electron-accepting groups or a hole transport film containing electron-donating groups; the Z-component film may be a hole transport film, an electron transport film, a light-harvesting film or an adhesive film. In addition, as shown in (6) and (7), the Z-component film may be omitted.

Herein, the adhesive film does not contain any of electron-donating groups, photosensitive groups, and electron-accepting groups. In the drawing, subscript numerals such as "75" and "25" as in "X₇₅Y₂₅ film" indicate a ratio of the X component to the Y component, and films containing the X component and the Y component at a specific ratio are collectively and simply indicated as "XY film".

As shown in FIG. 6A, in the composite layer 13, the XY films containing the X component and the Y component at a specific ratio and the Z films are alternately stacked: for example, the X-component film, the Z-component film, a X₇₅Y₂₅ film containing 75% of the X component and 25% of the Y component, the Z-component film, ... (omitted) ... and the Y-component film, in this order. In addition, the ratio of the X component to the Y component in the XY film is set in such a manner that a concentration gradient is formed in a film thickness direction.

Two XY films sandwiching a Z-component film are connected to each other by a plurality of XY film connectors 45 that penetrate through the Z-component film. Likewise, two Z-component films sandwiching an XY-component film are connected to each other by a plurality of Z film connectors 46 that penetrate through the XY film.

### (Production method)

The composite layer 13 having a concentration gradient in the film thickness direction can be produced in the following manner. There are prepared a Z-component vessel that contains an aqueous solution of cation (anion) to which the Z component is introduced, and a plurality of XY-component vessels that contain aqueous solutions of anion (cation) having a stepwise varied ratio (content) of the X component to the Y component. First, the substrate electrode (electrode 21) is immersed in the solution in the XY-component vessel, and then in the solution in the Z-component vessel. These procedures are repeated, while the XY-component vessel is sequentially replaced with one with different ratio so that a concentration gradient is formed as a whole. Finally, the counter electrode (electrode 22) is formed by evaporation and the like, to thereby obtain the photoelectric device 33.

### (Description of working mechanism)

With the combination (1) of FIG. 6B in the composite layer 13, all light-harvesting films (Z-component films) are surrounded by the XY films in which electron-donating groups and electron-accepting groups are mixedly present. Therefore, hole (+) and electron (-) generated by charge separation at the interface are transported to the respective electrodes 21, 22 through the XY films.

With the combination (2) of FIG. 6B in the composite layer 13, all hole transport films (Z-component films) are surrounded by the XY films in which electron-donating groups and photosensitive groups are mixedly present. Therefore, hole (+) generated by charge separation at the interface is transported to the electrode 21 through the Z-component films, and electron (-) generated likewise is transported to the electrode 22 through the XY films in which photosensitive groups and electron-accepting groups are mixedly present.

With the combination (3) of FIG. 6B in the composite layer 13, all electron transport films (Z-component films) are surrounded by the XY films in which electron-donating groups and photosensitive groups are mixedly present. Therefore, electron (-) generated by charge separation at the interface is transported to the electrode 22 through the Z-component films, and hole (+) generated likewise is transported to the electrode 22 through the XY films in which photosensitive groups and electron-donating groups are mixedly present.

With each of the combinations (4) and (6) of FIG. 6B in the composite layer 13, hole (+) and electron (-) generated by charge separation at the interface are transported to the respective electrodes 21,22 through the XY films in which photosensitive groups and electron-accepting groups are mixedly present.

With each of the combinations (5) and (7) of FIG. 6B in the composite layer 13, hole (+) and electron (-) generated by charge separation at the interface are transported to the respective electrodes 21,22 through the XY films in which photosensitive groups and electron-donating groups are mixedly present.

The photoelectric device 33 according to the third embodiment has been described as a monolayer structure of the composite layer 13. However, between the composite layer 13 and the electrode 21 or 22, at least one of the electron transport layer Nx and the hole transport layer Px may be sandwiched, as shown in FIGs. 7A - 7D.

### Example 1

Hereinafter, a production of an organic thin film having a multilayer structure of the present invention will be described. In addition, power generation properties will be compared between a photoelectric device using the organic thin film of the present invention and the conventional photoelectric device as Comparative Example.

### <Hydrophilic treatment of transparent electrode>

First, an ultrasonic treatment was applied to a transparent electrode, such as ITO substrate in toluene, acetone and ethanol solutions for 20 minutes each. Next, the transparent electrode was boiled in an alkaline piranha solution (distilled water: 30%-hydrogen peroxide solution: 25 %-concentrated ammonia water = 5:1:1) at 80°C for 15 minutes, to thereby negatively charge a surface of the substrate. It should be noted that the surface of the substrate can be made hydrophilic by a UV-ozone treatment with an ozone cleaner for 1 hour, instead of using the piranha solution.

A formation of a composite layer 11 of the photoelectric device 31 by alternate layer-by-layer adsorption method will be described below. First, a preparation of electrolyte solutions required for forming the composite layer 11 will be described.

### <Preparation of light-harvesting polycation solution (Ru solution)>

A light-harvesting polycation (Ru) solution required for forming the light-harvesting film A included in the composite layer 11 is prepared in the following manner. First, radical copolymerization of choline methacrylate and bipyridyl methacrylate (4-(methacryloylmethyl)-4'-methyl-2,2'-bipyridine) is performed in ethanol, to thereby obtain copolymer.

The copolymer is purified by reprecipitation using ethanol as a good solvent and acetone as a poor solvent, and by ligand-substitution reaction with bis(2,2'-bipyridyl)dichloro-ruthenium(II) complex, polycation having a ruthenium complex as a side chain is synthesized. After this complexing, the polycation is purified by reprecipitation using ethanol as a good solvent and methylene chloride as a poor solvent. The obtained polymer is dissolved in ultrapure water to thereby obtain 10mM of an aqueous solution (light-harvesting polycation) (see FIG. 8A(5)).

### <Preparation of hole transport polyanion solution (PEDOT solution)>

A hole transport polyanion (PEDOT) solution required for forming the hole transport film P included in the composite layer 11 is prepared in the following manner. First, ultrapure water is added to 1.3wt%-PEDOT/PSS (0.5wt%-PEDOT + 0.8wt%-PSS), to thereby prepare 10mM of a PEDOT/PSS aqueous solution (hole transport polyanion). A supersonic treatement is applied to the solution for 2 minutes to thereby enhance dispersibility, and the solution is passed through a filter having a pore diameter of 0.45 mm, which gave a hole transport polyanion (PEDOT) solution (see FIG. 8A(1)).

### <Preparation of polycation solution (PCM solution)>

A polycation (PCM) solution required for forming the adhesive film to be used in the formation of a single layer of the electron transport layer Nx or the hole transport layer Px by alternate layer-by-layer adsorption method, which has been described in the embodiments above, is prepared in the following manner. First, radical polymerization of choline methacrylate is performed in ethanol, to thereby obtain polyelectrolyte PCM, which is then purified by reprecipitation using ethanol as a good solvent and acetone as a poor solvent. The obtained polymer is dissolved in ultrapure water to thereby obtain 10mM of an aqueous solution (polycation) (see FIG. 8B(8)).

### <Preparation of polyanion solution (PAA solution)>

Likewise, a polyanion (PAA) solution required for forming the adhesive film to be used in the formation of a single layer by alternate layer-by-layer adsorption method is prepared in the following manner. First, 10mM of a 35wt%-polyacrylic acid aqueous solution (polyanion) is prepared, and pH is adjusted to 6.5 by adding an appropriate amount of a sodium hydroxide aqueous solution (see FIG. 8B(10)).

### <Preparation of linsing solution>

For a rinsing solution to be used in rinse bathing, ultrapure water is used which can be prepared by distilling ion-exchange water and passing the distilled water through a filter for obtainng ultrapure water (Barnstead II).

Each of the thus obtained polyelectrolyte aqueous solutions and ultrapure water in an amount of 30 mL was charged in a 50 x 50 ϕmm weight bottle, and the bottles were placed on a turntable in a specific order. Adsorption conditions were as follows: immersion time of 5 minutes, rinsing time of 3 minutes, drying time of 2 minutes, temperature of 21-24 °C, and humidity of 50-60 %. Pulling-out and immersion of the substrate was performed using a stepping motor at a speed of 0.6 mm/s.

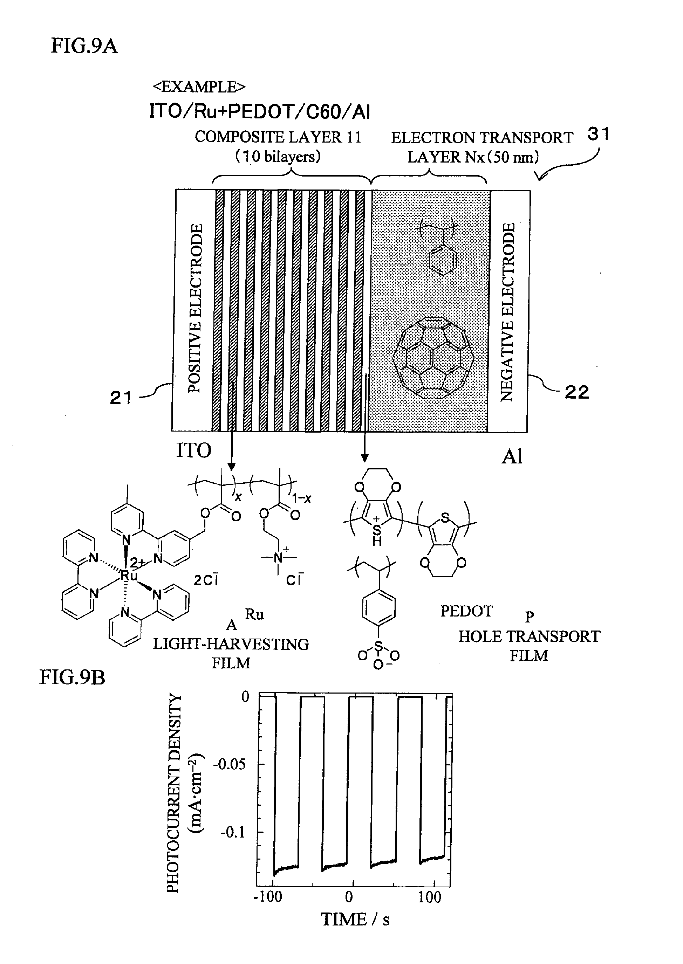

First, a photoelectric device 31 having a composite layer 11 (ITO/PEDOT+Ru/C₆₀/Al) with a configuration type of [transparent electrode / composite layer (hole transport film + light-harvesting film) / electron transport layer / metal electrode] will be described (see FIG. 9A).

### <Formation of composite layer 11>

First, an ITO substrate (transparent electrode) 21 to which a hydrophilic treatment had been applied was immersed in the Ru solution for 5 minutes, pulled out from the solution, allowed to dry for 2 minutes, immersed in ultrapure water for 3 minutes, pulled out from the water and allowed to dry for 2 minutes. Subsequently, the substrate was immersed in the PEDOT solution for 5 minutes, pulled out from the solution, allowed to dry for 2 minutes, immersed in ultrapure water for 3 minutes, pulled out from the water and allowed to dry for 2 minutes. As a result, a pair of Ru film and PEDOT film was formed on the ITO substrate. This procedure was repeated 10 times, to thereby obtain a composite layer 11 composed of 10 pairs of Ru+PEDOT films on the electrode.

### <Formation of electron transport layer Nx>

Next, 4 mg of polystyrene and 16 mg of C₆₀ were added to 1 mL of ortho-dichlorobenzene and an ultrasonic treatment was applied to the mixture for 1 hour, to thereby obtain a homogeneous solution. The solution was cast over a surface of the formed composite layer 11, and spin coating was performed. A rotation speed was 400 rpm for an initial 10 seconds, and 1,000 rpm for the subsequent 99 seconds. A polymer film was obtained by the spin coating, from which the solvent was removed by vacuum drying for 12 hours, to thereby obtain an electron transport layer Nx.

### <Formation of counter electrode>

A counter electrode 22 was formed on the electron transport layer Nx by evaporating aluminum with a vacuum evaporator. Evaporation at a speed of 2 nm s⁻¹ for 50 seconds gave an aluminum electrode 22 with a thickness of 50 nm.

In this manner, there was obtained a photoelectric device 31 (ITO/PEDOT+Ru/C_{60/}Al) having a composite layer 11 composed of the hole transport film P and the light-harvesting film A alternately stacked on each other, as shown in the schematic diagram of FIG. 9A.

### <Comparative Example>

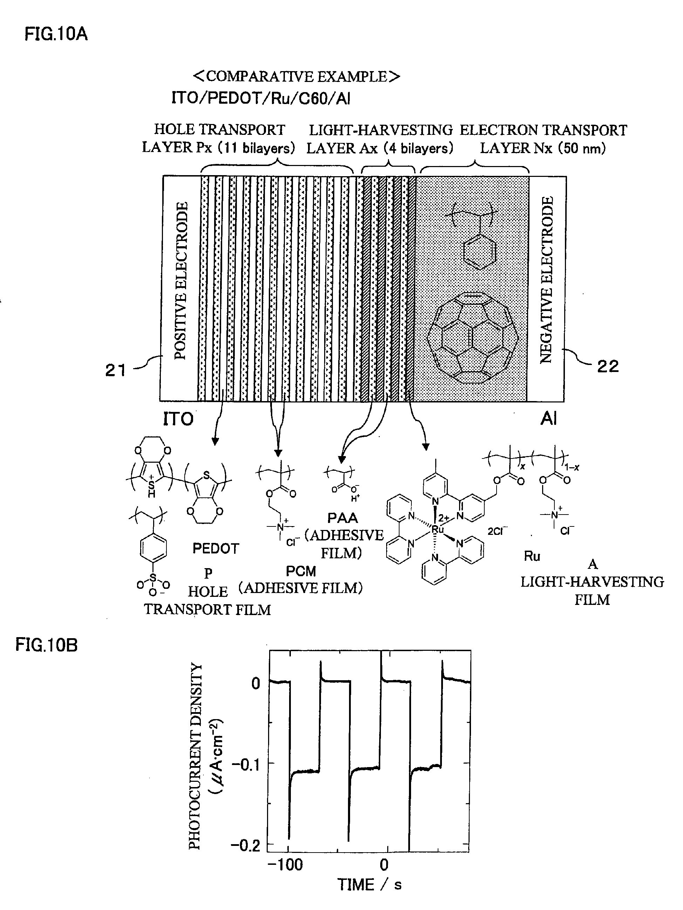

Next as a comparative example, a photoelectric device (ITO/PEDOT/Ru/C₆₀/Al) with a configuration type of [transparent electrode / hole transport layer / light-harvesting layer / electron transport layer / metal electrode], in which the hole transport film and the light-harvesting film forming the above-mentioned composite layer is replaced with a monolayer of the hole transport layer Px or the light-harvesting layer Ax, was produced in the following manner (see FIG. 10A).

First, an ITO substrate 21 to which a hydrophilic treatment had been applied was immersed in the PCM solution for 5 minutes, pulled out from the solution, allowed to dry for 2 minutes, immersed in ultrapure water for 3 minutes, pulled out from the water and allowed to dry for 2 minutes. Subsequently, the substrate was immersed in the PEDOT solution for 5 minutes, pulled out from the solution, allowed to dry for 2 minutes, immersed in ultrapure water for 3 minutes, pulled out from the water and allowed to dry for 2 minutes. As a result, a pair of PEDOT film and PCM film was formed on the ITO substrate 21. This procedure was repeated 11 times, to thereby obtain a PEDOT (hole transport) layer Px composed of 11 pairs of PEDOT/PCM films. The PCM film functions as an adhesive film.

Next, the PAA solution and the Ru solution were used instead of the PEDOT solution and the PCM solution, respectively, and substantially the same procedure was repeated for four times each, to thereby obtain a Ru (light-harvesting) layer Ax composed of 4 pairs of Ru/PAA films.

Further, in the same manner as in Example 1, an electron transport layer Nx and a counter electrode 22 were formed in this order on the light-harvesting layer Ax.

In this manner, there was obtained a photoelectric device (ITO/PEDOT/Ru/C₆₀/Al) in which the hole transport layer Px and the light-harvesting layer Ax are formed as separate monolayers, as shown in the schematic diagram of FIG. 10.

### <Data comparison>

FIG. 9B and FIG. 10B show observation data of photocurrent response obtained by radiating light ray on the photoelectric devices shown in FIG. 9A and FIG. 10A, respectively.

These observation data were obtained by connecting an I-V meter to the corresponding photoelectric device (ITO/PEDOT+Ru/C₆₀/Al, ITO/PEDOT/Ru/C₆₀/Al), and measuring photocurrent response in a short-circuited state (V = 0). As an irradiation light source, a 500W-xenon lamp was used, and white light (light ray) of 50 mW cm⁻² was intermittently radiated on an ITO substrate side.

Comparison of two observation data reveals improvement in photocurrent response value by 1000 times; the photocurrent response value of the photoelectric device having discrete monolayers (ITO/PEDOT/Ru/C₆₀/Al) as a comparative example was approximately 0.1 µA cm⁻², while the photocurrent response value of the photoelectric device having a composite layer (ITO/PEDOT+Ru/C₆₀/Al) as an example was approximately 0.1 mA cm⁻².

Moreover, a hole transport layer (PEDOT) was further provided between the transparent electrode and the composite layer in the photoelectric device to form a photoelectric device having a composite layer (ITO/PEDOT/PEDOT+Ru/C₆₀/Al), and it proves that a photocurrent response value is further improved.

This hole transport layer is formed by alternate layer-by-layer adsorption method in which an ITO substrate is alternately immersed in a PEDOT solution and a PCM solution. After forming an ITO/PEDOT film, a composite layer, an electron transport layer, and a metal electrode are subsequently formed in this order, as described above.

Alternatively, the electron transport layer (C₆₀) may be formed by alternate layer-by-layer adsorption method. In this case, after forming the composite layer (PEDOT+Ru), the electron transport layer (C₆₀) is formed by alternately immersing an ITO substrate in a C₆₀C(COONa)₂ solution (electron transport polyanion) (see FIG. 8A(7)) and a polydiallyldimethylammonium (PDDA) solution (polycation) (see FIG. 8B(9)). Other examples of the method for forming the electron transport layer (C₆₀) include vacuum deposition and a method in which a counter electrode is coupled through conductive liquid crystal or electrolyte.

In this manner, even when the electron transport layer (C₆₀) was formed by different film-forming method, the photocurrent response value of the photoelectric device was improved similarly.

### Example 2

Next, a photoelectric device having a composite layer (Au/PEDOT/PEDOT+Ru/C₆₀/SnO₂/ITO) with a configuration type of [metal electrode / hole transport layer / composite layer (hole transport film + light-harvesting film) / charge separation layer / electron transport layer / transparent electrode] will be described.

### <Formation of tin oxide (electron transport layer)/transparent electrode >

On an ITO substrate (transparent electrode) which had been washed by the above-mentioned method, a 15wt% colloidal solution of SnO₂ fine particle (up to 15 nm) (containing potassium ion as stabilizer) was cast while spinning. The substrate was dried and fired at 400°C for 1 hour in an electric furnace, to thereby obtain an SnO₂ transparent electrode.

### <Fixation of C₆₀(C(COOH)₂)₂ (charge separation layer) >

The SnO₂ transparent electrode was washed with toluene and acetone solutions, immersed in a bromobenzene solution containing 1 mM of C₆₀(C(COOH)₂)₂ (see FIG. 8C(12)) and 1 mM of 1H-benzotriazol-1-ol and cooled to 0°C. After an addition of dicyclohexylcarbodiimide, the mixture including the transparent electrode was stirred at room temperature to thereby promote fixation. The amount of the fixed C₆₀(C(COOH)₂)₂ can be arbitrarily controlled by altering immersion time.

### <Formation of composite layer (hole transport film + light-harvesting film) and hole transport layer >

A composite layer composed of 10 pairs of Ru+PEDOT films was formed by alternate layer-by-layer adsorption method using the above-mentioned Ru solution and PEDOT solution. Subsequently, a hole transport layer composed of 10 pairs of PEDOT+PCM films was formed by alternate layer-by-layer adsorption method using the PEDOT solution and the PCM solution.

### <Formation of counter electrode>

A counter electrode was formed on the hole transport layer by evaporating gold with a vacuum evaporator. Evaporation at a speed of 2 nms⁻¹ for 50 seconds gave a gold electrode with a thickness of 50 nm.

On the obtained photoelectric device (Au/PEDOT/PEDOT+Ru/C₆₀/SnO₂/ITO), white light (light ray) was radiated from a xenon lamp in the same manner as described above and photocurrent response was observed. Likewise, observation reveals an improvement in photoelectric current due to an introduction of the composite layer.

In addition, even when a layer other than functional composite layer (hole transport layer and charge separation layer) was formed by different film-forming method (casting, vacuum deposition), a similar effect was obtained. Moreover, a device with a hole transport layer in which a counter electrode was coupled through conductive liquid crystal or electrolyte showed a similar effect.

It was also shown that photoelectric current was improved in a photoelectric device (Au/PEDOT/PEDOT+Ru/SnO₂/ITO) with a configuration type of [metal electrode / hole transport layer / composite layer (hole transport film + light-harvesting film) / electron transport layer / transparent electrode], in which the charge separation layer (C₆₀) was omitted.

### Example 3

Next, a photoelectric device having a composite layer (Au/PEDOT/Ru+C₆₀/C₆₀/SnO₂/ITO) with a configuration type of [metal electrode / hole transport layer / composite layer (light-harvesting film + electron transport film) / charge separation layer / electron transport layer /transparent electrode] will be described.

The photoelectric device was produced in the following manner. On the C₆₀-SnO₂ (charge separation/electron transport) transparent electrode as obtained above, a composite layer composed of Ru+C₆₀ films was formed by alternate layer-by-layer adsorption method using the Ru solution and the C₆₀C(COONa)₂ solution; and subsequently a hole transport layer composed of PEDOT films was formed by alternate layer-by-layer adsorption method using the PEDOT solution and the PCM solution. Then, a counter electrode by vacuum deposition using Au was formed in the same manner as described above, to obtain a photoelectric device (Au/PEDOT/Ru+C₆₀/C₆₀/SnO₂/ITO). Observation of photocurrent response reveals a similar improvement in photoelectric current.

It was also shown that that photoelectric current was improved in a photoelectric device (Au/PEDOT/Ru+C₆₀/SnO₂/ITO) with a configuration type of [metal electrode / hole transport layer / composite layer (light-harvesting film + electron transport film) / electron transport layer / transparent electrode], in which the charge separation layer (C₆₀) was omitted.

### Example 4

Next, a photoelectric device having a composite layer (ITO/PEDOT/Ru+C₆₀/C₆₀/Al) with a configuration type of [transparent electrode / hole transport layer / composite layer (light-harvesting film + electron transport film) / electron transport layer/ metal electrode] will be described.

The photoelectric device was produced by, on the ITO substrate, forming a hole transport layer composed of PEDOT films by alternate layer-by-layer adsorption method using the PEDOT solution and the PCM solution; subsequently forming a composite layer composed of Ru+C₆₀ films by alternate layer-by-layer adsorption method using the Ru solution and the C₆₀C(COONa)₂ solution; further forming an electron transport layer composed of C₆₀ films by alternate layer-by-layer adsorption method using the C₆₀C(COONa)₂ solution and the PDDA solution; and finally forming a counter electrode by vacuum deposition using Al. Observation of photocurrent response reveals a similar improvement in photoelectric current.

It was also shown that photoelectric current was improved in a photoelectric device (ITO/Ru+C₆₀/C₆₀/Al) with a configuration type of [transparent electrode / composite layer (light-harvesting film + electron transport film) / electron transport layer / metal electrode], in which the hole transport layer (PEDOT) was omitted.

### Example 5

Next, a photoelectric device having a concentration gradient-type composite layer with a configuration type of [metal electrode / hole transport layer / composite layer (hole transport film + light-harvesting film + electron transport film) / electron transport layer / transparent electrode] will be described.

The photoelectric device was produced by, on the SnO₂ (electron transport) transparent electrode as obtained above, forming PEDOT+Ru+C₆₀ (concentration gradient) films using a mixed solution of the PEDOT solution and the C₆₀C(COONa)₂ solution as a polyanion solution and the Ru solution as a polycation solution. For this formation, there were prepared five different mixed solutions with composition (molar) ratios of PEDOT:C₆₀C(COONa)₂ = 10:0, 7:3, 5:5, 3:7 and 0:10 (i.e., (PEDOT | C₆₀) x: (PEDOT composition)x = 100, 70, 50, 30 and 0 %).

An ITO/SnO₂ electrode was immersed alternately in the Ru solution and a (PEDOT | C₆₀)₁₀₀ solution for four times each, alternately in the Ru solution and a (PEDOT | C₆₀)₁₀₀ solution for four times each, alternately in the Ru solution and a (PEDOT | C₆₀)₅₀ solution for four times each, alternately in the Ru solution and a (PEDOT|C₆₀)₃₀ solution for four times each, and alternately in the Ru solution and a (PEDOT|C₆₀)₀ solution for four times each, to thereby obtain 20 pairs of films.

Subsequently, a hole transport layer composed of PEDOT films was formed by alternate layer-by-layer adsorption method using the PEDOT solution and the PCM solution. Vacuum drying was applied, and a counter electrode was formed by vacuum deposition using Au. Observation of photocurrent response reveals improved photoelectric current due to an introduction of concentration gradient.

### Example 6

Next, a photoelectric device having a concentration gradient-type composite layer with a configuration type of [transparent electrode / hole transport layer / composite layer (hole transport film + light-harvesting film + electron transport film) / electron transport layer / metal electrode] will be described.

The photoelectric device was produced by: on the ITO substrate, forming a hole transport layer composed of PEDOT films by alternate layer-by-layer adsorption method using the PEDOT solution and the PCM solution; forming a concentration gradient-type composite layer composed of PEDOT+Ru+C₆₀ films in the same manner as described above; subsequently forming an electron transport layer composed of C₆₀ films by alternate layer-by-layer adsorption method using the C₆₀C(COONa)₂ solution and the PDDA solution; applying vacuum drying; and forming a counter electrode by vacuum deposition using Al. Observation of photocurrent response reveals an improvement in photoelectric current due to an introduction of concentration gradient.

It was also shown that photoelectric current was improved in a photoelectric device with a configuration type of [transparent electrode / composite layer (hole transport film + light-harvesting film + electron transport film) / electron transport layer / metal electrode], in which the hole transport layer (PEDOT) was omitted.

### Example 7

Next, a photoelectric device having a concentration gradient-type composite layer with a configuration type of [metal electrode / hole transport layer / composite layer (hole transport film + light-harvesting film) / electron transport layer / transparent electrode] will be described.

The photoelectric device was produced by: on the SnO₂ (electron transport) transparent electrode as obtained above, forming a concentration gradient-type composite layer composed of PEDOT+C₆₀ films by alternate layer-by-layer adsorption method using a mixed solution of the PEDOT solution and the C₆₀C(COONa)₂ solution as a polyanion solution and the PCM solution as a polycation solution; subsequently forming PEDOT (hole transport) films by alternate layer-by-layer adsorption method using the PEDOT solution and the PCM solution; applying vacuum drying; and finally forming a counter electrode by vacuum deposition using Au. Observation of photocurrent response reveals an improvement in photoelectric current due to an introduction of concentration gradient.

### Example 8

Next, a photoelectric device having a concentration gradient-type composite layer with a configuration type of [transparent electrode / hole transport layer / composite layer (hole transport film + light-harvesting film) / electron transport layer / metal electrode] will be described.

The photoelectric device was produced by: on the ITO substrate, forming a hole transport layer composed of PEDOT film by alternate layer-by-layer adsorption method using the PEDOT solution and the PCM solution; forming a concentration gradient-type composite layer composed of PEDOT+C₆₀ films in the same manner as described above; subsequently forming an electron transport layer composed of C₆₀ films by alternate layer-by-layer adsorption method using the C₆₀C(COONa)₂ solution and the PDDA solution; applying vacuum drying; and finally forming a counter electrode by vacuum deposition using Al. Observation of photocurrent response reveals an improvement in photoelectric current due to an introduction of concentration gradient.

It was also shown that photoelectric current was improved in a photoelectric device with a configuration type of [transparent electrode / composite layer (hole transport film + light-harvesting film) / electron transport layer / metal electrode], in which the hole transport layer (PEDOT) was omitted.

### Example 9

Next, a photoelectric device having a concentration gradient-type composite layer with a configuration type of [metal electrode / hole transport layer / composite layer (light-harvesting film + electron transport film) / electron transport layer / transparent electrode] will be described.

The photoelectric device was produced by, on the SnO₂ (electron transport) transparent electrode as obtained above, forming a concentration gradient-type composite layer composed of CuPcS+C₆₀ films using a mixed solution of a copper phthalocyanine sulfonic acid (CuPcS) solution (light-harvesting polyanion) (see FIG. 8A(3)) and the C₆₀C(COONa)₂ solution as a polyanion solution and the PDDA solution as a polycation solution.

For this formation, there were prepared five different mixed solutions with composition (molar) ratios of CuPcS:C₆₀C(COONa)₂ = 10:0, 7:3, 5:5, 3:7 and 0:10 (i.e., (CuPcS|C₆₀)x:(CuPcS composition) x = 100, 70, 50, 30 and 0 %). A SnO₂ electrode was immersed alternately in the PDDA solution and a (CuPcS|C₆₀)₁₀₀ solution for four times each, alternately in the PDDA solution and a (CuPcS | C₆₀)₇₀ solution for four times each, alternately in the PDDA solution and a (CuPcS | C₆₀)₅₀ solution for four times each, alternately in the PDDA solution and a (CuPcS | C₆₀)₃₀ solution for four times each, and alternately in the PDDA solution and a (CuPcS|C₆₀)₀ solution for four times each, to thereby obtain a concentration gradient-type composite layer composed of 20 pairs of CuPcS+C₆₀ films.

Subsequently, a hole transport layer composed of PEDOT films was formed by alternate layer-by-layer adsorption method using the PEDOT solution and the PCM solution. Vacuum drying was applied, and a counter electrode was formed by vacuum deposition using Au, to thereby obtain a photoelectric device. Observation of photocurrent response reveals improved photoelectric current due to an introduction of concentration gradient.

### Example 10

Next, a photoelectric device having a concentration gradient-type composite layer with a configuration type of [transparent electrode / hole transport layer / composite layer (light-harvesting film + electron transport film) / electron transport layer / metal electrode] will be described.

The photoelectric device was produced by: on the ITO substrate, forming a hole transport layer composed of PEDOT film by alternate layer-by-layer adsorption method using the PEDOT solution and the PCM solution; subsequently forming a concentration gradient-type composite layer composed of CuPcS+C₆₀ films in the same manner as described above; further forming an electron transport layer composed of C₆₀ films by alternate layer-by-layer adsorption method using the C₆₀C(COONa)₂ solution and the PDDA solution; applying vacuum drying; and finally forming a counter electrode by vacuum deposition using Al. Observation of photocurrent response reveals an improvement in photoelectric current due to an introduction of concentration gradient.

It was also shown that photoelectric current was improved in a photoelectric device with a configuration type of [transparent electrode / composite layer (light-harvesting film + electron transport film) / electron transport layer / metal electrode], in which the hole transport layer (PEDOT) was omitted.

### Example 11

Next, a photoelectric device having a concentration gradient-type composite layer with a configuration type of [transparent electrode / composite layer (light-harvesting film + electron transport film) / metal electrode] will be described.

The composite layer of this photoelectric device was produced by using a mixed solution of a poly(para-phenylene vinylene) (PPV) precursor solution (light-harvesting polycation) (see FIG. 8A(2)) and a fullerene cation (C₆₀C₄H₁₀N) solution (electron transport polycation) (see FIG. 8A(6)) as a polycation solution; and a mixed solution of a polythiophenesulphonic acid (PTS) solution (light-harvesting polyanion) (see FIG. 8A(4)) and the C₆₀C(COONa)₂ solution (electron transport polyanion) as a polyanion solution.

For this formation, there were prepared five different mixed solutions with composition (molar) ratios of PPV:C₆₀C₄H₁₀N₂ = 10: 0, 7:3, 5:5, 3:7 and 0:10 (i.e., (PPV|C₆₀)x: (PPV composition)x = 100, 70, 50, 30 and 0 %), and five different mixed solutions with a composition (molar) ratio of PTS:C₆₀C(COONa)₂ = 10:0, 7:3, 5:5, 3:7 and 0:10 (i.e., (PTS|C₆₀)x:(PEDOT composition) x = 100, 70, 50, 30 and 0 %).

An ITO substrate was immersed alternately in a (PPV|C₆₀)₁₀₀ solution and a (PTS|C₆₀)₁₀₀ solution for four times each, alternately in a (PPV|C₆₀)₇₀ solution and a (PTS|C₆₀)₇₀ solution for four times each, alternately in a (PPV|C₆₀)₅₀ solution and a (PTS|C₆₀)₅₀ solution for four times each, alternately in a (PPV|C₆₀)₃₀ solution and a (PTS |C₆₀)₃₀ solution for four times each, and alternately in a (PPV|C₆₀)₀ solution and a (PTS|C₆₀)₀ solution for four times each, to thereby obtain a concentration gradient-type composite layer composed of 20 pairs of PPV|PTS+C₆₀ films.

After drying, annealing was performed at 220°C in vacuum, to thereby convert a PPV precursor into PPV (see FIG. 8A(2')). Then, a counter electrode was formed by vacuum deposition using Al. Observation of photocurrent response reveals improved photoelectric current due to an introduction of concentration gradient.

### Example 12

Next, a photoelectric device (ITO/PPV+PEDOT/C₆₀/Al) with a configuration type of [transparent electrode / composite layer (light-harvesting film + hole transport film) / electron transport layer / metal electrode], as shown in FIG. 11A, will be described.

First, in the same manner as in the method for producing the photoelectric device of FIG. 9A described above, the ITO substrate (transparent electrode) 21 to which a hydrophilic treatment had been applied was alternately immersed in the PPV solution and the PEDOT solution for 30 times each, to thereby form a composite layer 11 composed of 30 pairs of PPV+PEDOT films on the ITO electrode 21.

Next, in the same manner as in the method regarding FIG. 9A, an electron transport layer N with a thickness of 50 nm was formed on the composite layer 11, and an aluminum electrode 22 with a thickness of 50 nm was further formed thereon.

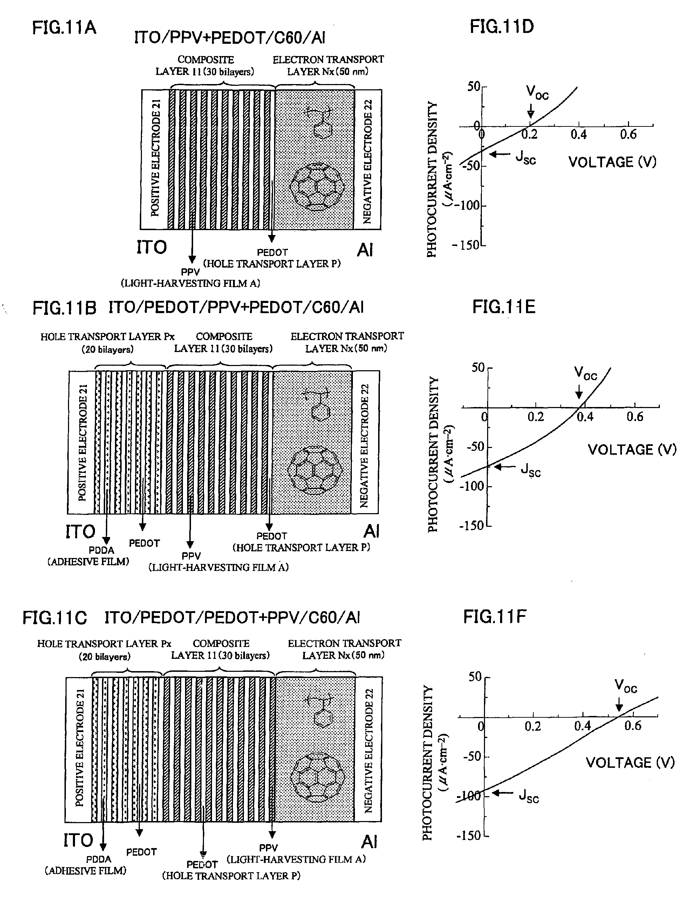

FIG. 11D shows observation data of photocurrent response, obtained by radiating light ray on the thus obtained photoelectric device (ITO/PPV+PEDOT/C₆₀/Al) (FIG. 11A). The conditions for obtaining the observation data of the photocurrent response are identical to the conditions used with respect to FIGs. 9B and 10B.

Next, a photoelectric device (ITO/PEDOT/PPV+PEDOT/C₆₀/Al) with a configuration type of [transparent electrode / hole transport layer / composite layer (light-harvesting film + hole transport film) / electron transport layer / metal electrode], as shown in FIG. 11B, will be described.

First, in the same manner as in the method for producing the hole transport layer P of the photoelectric device of FIG. 10A, the ITO substrate (transparent electrode) 21 to which a hydrophilic treatment had been applied was alternately immersed in the PDDA solution and the PEDOT solution for 20 times each, to thereby form a hole transport layer P composed of 20 pairs of PDDA+PEDOT films on the ITO electrode 21.

Next, in the same manner as in the method regarding FIG. 11A, a composite layer 11 composed of 30 pairs of PPV+PEDOT films was formed on the hole transport layer P, an electron transport layer N with a thickness of 50 nm was formed thereon, and an aluminum electrode with a thickness of 50 nm was further formed thereon.

FIG. 11E shows observation data of photocurrent response, obtained by radiating light ray on the thus obtained photoelectric device (ITO/PEDOT/PPV+PEDOT/C₆₀/Al) (FIG. 11B). The conditions for obtaining the observation data of the photocurrent response are identical to the conditions used with respect to FIG. 11D.

Next, a photoelectric device (ITO/PEDOT/PEDOT+PPV/C₆₀/Al) with a configuration type of [transparent electrode / hole transport layer / composite layer (hole transport film + light-harvesting film) / electron transport layer / metal electrode], as shown in FIG. 11C, will be described.

A difference between the photoelectric device (ITO/PEDOT/PEDOT+PPV/C₆₀/Al) shown in FIG. 11C and the photoelectric device (ITO/PEDOT/PPV+PEDOT/C₆₀/Al) shown in FIG. 11B is that a film brought into contact with the electron transport layer (N layer) at an interface is PEDOT (hole transport film P) in the latter while PPV (light-harvesting film A) in the former. Therefore, in the production of the photoelectric device shown in FIG. 11C, a single layer of PPV is further provided on the composite layer 11 of FIG. 11B.

FIG. 11F shows observation data of photocurrent response, obtained by radiating light ray on the thus obtained photoelectric device (ITO/PEDOT/PEDOT+PPV/C₆₀/Al) (FIG. 11C). The conditions for obtaining the observation data of the photocurrent response are identical to the conditions used with respect to FIG. 11D.

As is apparent from the comparison between FIG.s 11D and 11E, by adding a hole transport layer Px to a configuration of FIG. 11A to form a configuration of FIG. 11B, an open voltage V_{oc} is raised from 0.20V to 0.38V, and a short-circuit current J_{sc} is raised from 30 µA/cm² to 74 µA/cm².

To sum up, these experimental data demonstrate that a specific effect can be obtained by inserting the hole transport layer Px or the electron transport layer Nx between the composite layer (11, 12 or 13) and the electrode (21 or 22), as in the configurations of the photoelectric devices 31' , 31", 32' and 32" shown in FIG. 7. The reason for this effect is believed that addition of the hole transport layer Px or the electron transport layer Nx to the composite layer 11 improves insulation performance between the electrodes 21, 22 without increasing internal resistance of the photoelectric device.

As is apparent from the comparison between FIGs. 11E and 11F, by replacing the PEDPT (hole transport film P) with the PPV (light-harvesting film A) as the boundary of the composite layer 11 brought into contact with the electron transport layer Nx, an open voltage V_{oc} is raised from 0.38V to 0.55V, and a short-circuit current J_{sc} is raised from 74 µA/cm² to 90 µA/cm².

To sum up, these experimental data demonstrate that the properties of the photoelectric device 31 vary depending on the film disposed on the boundary of the composite layer 11, as in the configurational difference between FIG. 1A and FIG. 1D, or in the configurational difference between FIG. 1B and FIG. 1C.

### Example 13

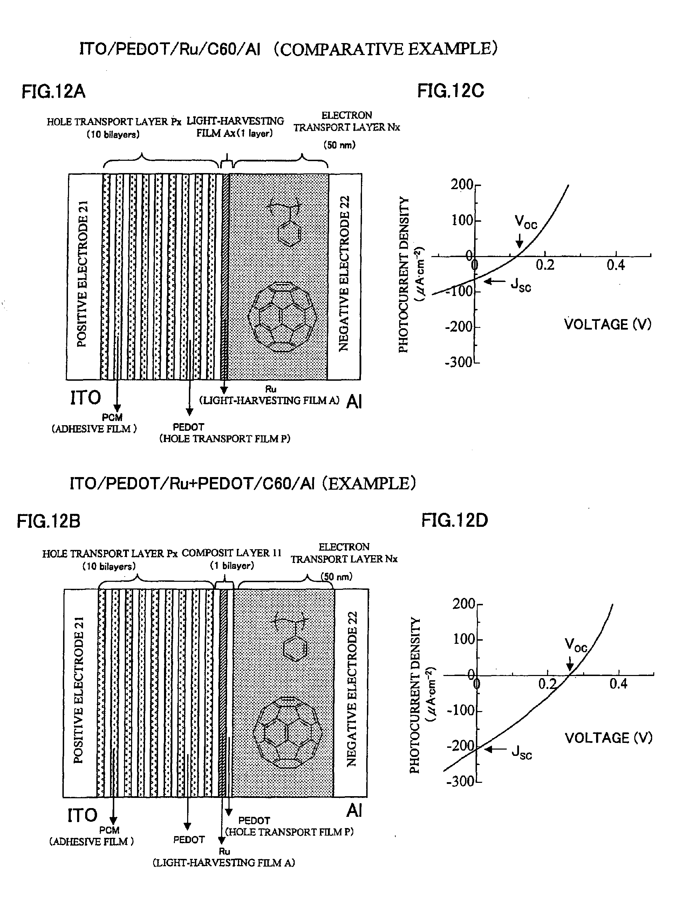

Next, a photoelectric device having a composite layer (ITO/PEDOT/Ru/C₆₀/Al) with a configuration type of [transparent electrode / hole transport layer / light-harvesting film / electron transport layer / metal electrode], as shown in FIG. 12A, will be described as a comparative example.

First, in the same manner as in the method for producing the hole transport layer Px of FIG. 10A, the ITO substrate (transparent electrode) 21 to which a hydrophilic treatment had been applied was alternately immersed in the PCM solution and the PEDOT solution for 10 times each, to thereby form a hole transport layer Px composed of 10 pairs of PCM+PEDOT films on the ITO electrode 21.

Next, a light-harvesting layer Ax composed of a monolayered Ru film was formed on the hole transport layer Px, an electron transport layer Nx with a thickness of 50 nm was formed thereon, and an aluminum electrode 22 with a thickness of 50 nm was further formed thereon.

FIG. 12C shows observation data of photocurrent response, obtained by radiating light ray on the thus obtained photoelectric device (ITO/PEDOT/Ru/C_{60/}Al) (FIG. 12A). The conditions for obtaining the observation data of the photocurrent response are identical to the conditions used with respect to FIGs. 9B and 10B.

Next, a photoelectric device having a composite layer (ITO/PEDOT/Ru+PEDOT/C_{60/}Al) with a configuration type of [transparent electrode / hole transport layer / composite layer (light-harvesting film + hole transport film) / electron transport layer / metal electrode], as shown in FIG. 12B, will be described.

A difference between the photoelectric device (ITO/PEDOT/Ru+PEDOT/C₆₀/Al) shown in FIG. 12B and the photoelectric device (ITO/PEDOT/Ru/C₆₀/Al) shown in FIG. 12A is that a film brought into contact with the electron transport layer Nx at an interface is Ru (light-harvesting film A) in the former while PEDOT (hole transport film P) in the latter. Therefore, in the production of the photoelectric device shown in FIG. 12B, a single layer of hole transport film P made of PEDOT is further provided on the light-harvesting film A made of Ru of FIG. 12A.

FIG. 12D shows observation data of photocurrent response, obtained by radiating light ray on the thus obtained photoelectric device (ITO/PEDOT/Ru+PEDOT/C_{60/}Al) (FIG. 12B). The conditions for obtaining the observation data of the photocurrent response are identical to the conditions used with respect to FIG. 12C.

As is apparent from the comparison between FIGs. 12C and 12D, by replacing the Ru (light-harvesting filmA) with the PEDPT (hole transport film P) as the boundary brought into contact with the electron transport layer Nx, an open voltage V_{OC} is raised from 0.12V to 0.25V, and a short-circuit current J_{SC} is raised from 60 uA/cm² to 200 µA/cm².

To sum up, these experimental data demonstrate that the properties of the photoelectric device 31 vary depending on the film disposed on the boundary of the composite layer 11, as in the configurational difference between FIG. 1A and FIG. 1D, or in the configurational difference between FIG. 1B and FIG. 1C. However, as compared with Example 12 in which properties are improved by disposing the light-harvesting film A at the boundary, the property variation of the photoelectric device based on the configurational difference shown in Example 13 is rather opposite. This may be resulted from a difference in hole transport properties between Ru and PPV to be used as a light-harvesting film A in Example 12 and Example 13, respectively.

## Claims

1. A photoelectric device having a composite layer and a pair of electrodes disposed on both sides of the composite layer, the composite layer comprising:
a 1st light-harvesting film that includes photosensitive groups which absorb light energy and are excited thereby,
a 1st hole transport film that neighbors the 1st light-harvesting film and includes electron-donating groups for donating electrons to the excited photosensitive groups,
an nth light-harvesting film (n=2, 3...) that includes photosensitive groups which absorb light energy that has passed through an (n-1) th light-harvesting film and are excited thereby,
an nth hole transport film (n=2, 3...) that is sandwiched between the nth light-harvesting film and the (n-1) th light-harvesting film and includes electron-donating groups for donating electrons to the excited photosensitive groups,
light-harvesting film connectors that penetrate the nth hole transport film and connect the (n-1) th light-harvesting film and the nth light-harvesting film, and
hole transport film connectors that penetrate the (n-1) th light-harvesting film and connect an (n-1) th hole transport film and the nth hole transport film.

2. A photoelectric device having a composite layer and a pair of electrodes disposed on both sides of the composite layer,
the composite layer comprising:
a 1st light-harvesting film that includes photosensitive groups which absorb light energy and are excited thereby,
a 1st electron transport film that neighbors the 1st light-harvesting film and includes an electron-accepting groups for accepting electrons from the excited photosensitive groups,
an nth light-harvesting film (n=2, 3...) that includes photosensitive groups which absorb light energy that has passed through an (n-1) th light-harvesting film and are excited thereby,
an nth electron transport film and an (n-1) th electron transport film that sandwiches the nth light-harvesting film and includes electron-accepting groups for accepting electrons from the excited photosensitive groups,
light-harvesting film connectors that penetrate the (n-1)th electron transport film and connect the (n-1) th light-harvesting film and the nth light-harvesting film,
electron transport film connectors that penetrate the nth light-harvesting film and connect the (n-1)th electron transport film and the nth electron transport film.

3. The photoelectric device according to Claim 1, wherein the 2nd - nth hole transport films further include photosensitive groups or electron-accepting groups, and contents thereof make a concentration gradient in a film thickness direction in accordance with a degree of n.

4. The photoelectric device according to Claim 2, wherein the 2nd - nth electron transport films further include electron-donating groups or photosensitive groups, and contents thereof make a concentration gradient in a film thickness direction in accordance with a degree of n.

5. The photoelectric device according to any one of Claims 1 to 4, wherein the 2nd - nth light-harvesting films further include electron-donating groups or electron-accepting groups, and contents thereof make a concentration gradient in a film thickness direction in accordance with a degree of n.

6. The photoelectric device according to Claim 5, wherein adhesive films are used instead of the 1st - nth hole transport films or the 1st - nth electron transport films.

7. The photoelectric device according to any one of Claims 1 to 6, further comprising an electron transport layer that is disposed between one of the electrodes and the composite layer and transports electrons generated by the excitation from the composite layer to the electrode.

8. The photoelectric device according to any one of Claims 1 to 7, further comprising a hole transport layer that is disposed between one of the electrodes and the composite layer and transports holes generated by the excitation from the composite layer to the electrode.

9. The photoelectric device according to Claim 7, wherein the composite layer has the light-harvesting film on a boundary with the electron transport layer.

10. The photoelectric device according to Claim 7, wherein the composite layer has the hole transport film on a boundary with the electron transport layer.

11. The photoelectric device according to Claim 8, wherein the composite layer has the light-harvesting film on a boundary with the hole transport layer.

12. The photoelectric device according to Claim 8, wherein the composite layer has the electron transport film on a boundary with the hole transport layer.

13. The photoelectric device according to any one of Claims 1 to 12, wherein the composite layer is formed by alternate layer-by-layer adsorption method.

14. A solar cell which uses the photoelectric device according to any one of Claims 1 to 13 and has a function of converting light energy into electrical energy and extracting the electrical energy as electric power.

15. A method for producing a photoelectric device comprising:
an electrode charging step in which a substrate electrode is negatively (or positively) charged,
a hole transport film adsorption step in which the charged substrate electrode is immersed in a solution of cation (or anion) to which electron-donating groups have been introduced, to cover a surface of the substrate electrode with a hole transport film formed by electrostatic adsorption and to positively (or negatively) charge the whole surface,
a light-harvesting film adsorption step in which the positively (or negatively) charged substrate electrode is immersed in a solution of anion (or cation) to which photosensitive groups have been introduced, to cover the surface with a light-harvesting film formed by electrostatic adsorption and to negatively (or positively) charge the whole surface,
an alternate adsorption step in which the light-harvesting film adsorption step and the hole transport film adsorption step are alternately repeated to form a composite layer on the substrate electrode, and
an electrode forming step in which a counter electrode is formed on the composite layer on a side thereof opposite to a substrate electrode-side.

16. A method for producing a photoelectric device comprising:
an electrode charging step in which a substrate electrode is negatively (or positively) charged,
an electron transport film adsorption step in which the charged substrate electrode is immersed in a solution of cation (or anion) to which electron-accepting groups have been introduced, to cover a surface of the substrate electrode with an electron transport film formed by electrostatic adsorption and to positively (or negatively) charge the whole surface,
a light-harvesting film adsorption step in which the positively (or negatively) charged substrate electrode is immersed in a solution of anion (or cation) to which photosensitive groups have been introduced, to cover the surface with a light-harvesting film formed by electrostatic adsorption and to negatively (or positively) charge the whole surface,
an alternate adsorption step in which the light-harvesting film adsorption step and the electron transport film adsorption step are alternately repeated to form a composite layer on the substrate electrode, and
an electrode forming step in which a counter electrode is formed on the composite layer on a side thereof opposite to a substrate electrode-side.

17. The method for producing photoelectric device according to Claim 15, wherein the solution of cation (or anion) to which electron-donating groups have been introduced and in which the substrate is repeatedly immersed in the alternate adsorption step further comprises photosensitive groups or electron-accepting groups, and a concentration thereof is stepwise changed every time the substrate electrode is immersed therein.

18. The method for producing photoelectric device according to Claim 16, wherein the solution of cation (or anion) to which electron-accepting groups have been introduced and in which the substrate is repeatedly immersed in the alternate adsorption step further comprises electron-donating groups or photosensitive groups, and a concentration thereof is stepwise changed every time the substrate electrode is immersed therein.

19. The method for producing photoelectric device according to any one of Claims 15 to 18, wherein the solution of cation (or anion) to which photosensitive groups have been introduced and in which the substrate is repeatedly immersed in the alternate adsorption step further comprises electron-donating groups or electron-accepting groups, and a concentration thereof is stepwise changed every time the substrate electrode is immersed therein.

20. The method for producing photoelectric device according to Claim 19, which comprises
instead of the hole transport film adsorption step or the electron transport film adsorption step,
an adhesive film adsorption step in which the charged substrate electrode is immersed in a solution of polyelectrolyte (cation or anion) having no electron-accepting property and no electron-donating property, to cover a surface of the substrate electrode with an adhesive film formed by electrostatic adsorption and to positively (or negatively) charge the whole surface.
